(19) Europäisches Patentamt
European Patent Office
Office européen des brevets

(11) EP 4 512 850 A1

(12) **EUROPEAN PATENT APPLICATION**
published in accordance with Art. 153(4) EPC

(43) Date of publication:
**26.02.2025 Bulletin 2025/09**

(21) Application number: **23791813.1**

(22) Date of filing: **17.04.2023**

(51) International Patent Classification (IPC):
***C08J 3/02*** *(2006.01)* ***C08F 212/14*** *(2006.01)*
***C08F 220/18*** *(2006.01)* ***G03F 7/039*** *(2006.01)*

(52) Cooperative Patent Classification (CPC):
**C08F 212/14; C08F 220/18; C08J 3/02; G03F 7/039**

(86) International application number:
**PCT/JP2023/015279**

(87) International publication number:
**WO 2023/204165 (26.10.2023 Gazette 2023/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.04.2022 JP 2022068512**

(71) Applicant: **Maruzen Petrochemical Co., Ltd.**
**Tokyo 104-8502 (JP)**

(72) Inventors:
- **NOJIMA, Masataka**
**Ichihara-shi, Chiba 290-8503 (JP)**
- **SUZUKI, Youji**
**Ichihara-shi, Chiba 290-8503 (JP)**
- **OIKAWA, Tomo**
**Ichihara-shi, Chiba 290-8503 (JP)**

(74) Representative: **Regimbeau**
**20, rue de Chazelles**
**75847 Paris Cedex 17 (FR)**

(54) **METHOD FOR PRODUCING POLYMER SOLUTION**

(57) [Problem] To provide a method capable of efficiently mass-producing a polymer solution which is useful for preparation of a resist composition for thick films, which has a high polymer concentration and which contains a plurality of solvents at a desired ratio.

[Solution] A method for producing a polymer solution containing C% by mass of a polymer in a mixed solvent of at least two or more solvents mixed at a predetermined mass ratio, in which an objective polymer solution is produced by estimating the polymer concentration and the solvent composition ratio of a "prepolymer solution" in which the solvent composition ratio in condensation of a polymer solution containing all the solvents, to an objective concentration C% by mass, is also just a predetermined value, thereby preparing and then condensing the prepolymer solution.

EP 4 512 850 A1

## Description

BACKGROUND OF THE INVENTION

Field of the Invention

The present invention relates to a method for producing a polymer solution including two or more solvents. More specifically, the invention relates to a method for producing a polymer solution including two or more solvents, useful for preparation of a resist composition.

Background Art

While ultrafine processing providing a line width of below 10 nm serves as an advanced technology for semiconductor manufacturing, three-dimensional processing technologies such as 3D-NAND are also advanced. Such three-dimensional processing requires resist films of several microns to several-tens of microns in thickness, and resist compositions, therefore, are demanded to have significant resist resin concentration and viscosity.

On the other hand, there are also found many examples in which resist compositions are formulated by mixed solvents in order to improve pattern shapes or improve properties, for example, enhance coatability. For example, Patent Literature 1 discloses a resin composition useful for thick resist, containing a solvent having a viscosity and a boiling point in specified ranges. Specifically, a resin composition is exemplified in which a copolymer of p-hydroxystyrene and tert-butyl methacrylate, an acid generator and any other additive are dissolved in various mixed solvents such as propylene glycol monomethyl ether acetate/ethyl acetate and propylene glycol monomethyl ether/cyclohexanone. Patent Literature 2 discloses a thick film photoresist composition containing 40% by mass or more of an organic solvent having a boiling point of 150°C or more at atmospheric pressure and having a contact angle with a silicon substrate, of 18 degrees or less, in the entire organic solvent. Specifically, a resist composition is disclosed in which a polymer to be increased in solubility in alkali with the action of acid, an alkali-soluble polymer, an acid generator, and an acid diffusion control agent are dissolved in a mixed solvent of propylene glycol monomethyl ether acetate and 3-methoxybutyl acetate and the polymer concentration is 49.5% by mass. Patent Literature 3 discloses a resist dry film applied as a PET film with a resist composition in which a copolymer of hydroxystyrene and amyloxystyrene, and an acid generator are dissolved in a mixed solvent of propylene glycol monomethyl ether acetate and propylene glycol or in a mixed solvent of propylene glycol monomethyl ether acetate and cyclopentanone at a polymer concentration of about 50% by mass. These resist compositions are each prepared by a method including mixing and dissolving a solid polymer, an acid generator and any other additive with and in a solvent. The method, while allowing for easy adjustment of the concentration of each component, is required to include sufficiently drying the polymer so as not to cause the polymerization solvent, the purification solvent, and the like used in polymer production to remain as impurities in the solid polymer. However, such a polymer for resist is liable to be decomposed or denatured due to heat, and therefore, it is not easy to highly dry a large amount of such a polymer in industrial production in terms of facilities and process time. Moreover, a lot of time is required to re-dissolve a large amount of the solid polymer in the solvent to provide a homogeneous solution, thereby causing an increase in production cost.

There is then performed a method for preparing a resist composition, including finishing a polymer in the form of a polymer solution without any dry solid formed during polymer production, and mixing the polymer with an acid generator, an additive and a solvent and dissolving them. As a method for preparing a polymer solution, Patent Literature 4 discloses a method including subjecting a polymerization liquid obtained by polymerization reaction, to precipitation purification, then re-dissolving a polymer in a solvent having a lower boiling point than a solvent used in a resist composition, and adding a resist solvent with distilling off the low-boiling point solvent by distillation under reduced pressure, to replace a solvent in a polymer solution with the resist solvent. Specifically, in Patent Literature 4, a resist polymer for ArF is obtained by polymerization, and then subjected to water washing, filtration, precipitation purification and rinse operations to provide a wet polymer, the wet polymer is dissolved in a mixed solvent of propylene glycol monomethyl ether acetate and propylene glycol monomethyl ether, and thereafter this solution is condensed to prepare a polymer solution for photoresist, in which the polymer concentration is 25% by weight. Patent Literature 5 and Patent Literature 6 each disclose a method for preparing a polymer solution for photoresist, containing a plurality of solvents. Specifically, in Patent Literature 5, a polymer solution for photoresist (PGMEA/PGME weight ratio = 7/3), in which the polymer concentration is 20% by weight, is prepared by forming a polymer having at least a repeating unit containing a group to be made alkali-soluble by the action of acid, and a repeating unit containing an alicyclic backbone having a polar group, by polymerization, subjecting the polymer to precipitation purification, dissolving a wet polymer separated, in propylene glycol monomethyl ether, removing a low-boiling point component by distillation, and then adding propylene glycol monomethyl ether acetate and propylene glycol monomethyl ether.

Citation List

Patent Literature

[Patent Literature 1] WO2018/061512
[Patent Literature 2] JP 2014-127518 A
[Patent Literature 3] JP 2019-105847 A
[Patent Literature 4] JP 2005-173252 A
[Patent Literature 5] JP 2006-161052 A
[Patent Literature 6] JP 2006-176574 A

SUMMARY OF THE INVENTION

Technical Problem

However, the method of Patent Literature 4 is required to include sufficiently distilling off the solvents (impurities) used in precipitation purification and rinse operations, during condensation, so that the solvents are not incorporated, and it is not always true that the impurities are sufficiently removed at the time where an objective polymer concentration is achieved by condensation. Moreover, propylene glycol monomethyl ether acetate and propylene glycol monomethyl ether are different in vapor pressure and thus different in speed of distillation during condensation, and the composition ratio of the mixed solvent after condensation is also liable to be not a desired value. On the other hand, the method of Patent Literature 5, while allows for easy removal of the impurities and easy adjustment of the polymer concentration and the composition ratio of the mixed solvent because of condensation of a polymer solution in one solvent of the mixed solvent and thereafter addition of another solvent, is not suitable for preparation of a polymer solution having a higher polymer concentration. For example, if preparation of a polymer solution in which the composition weight ratio between two solvents mixed is 1:1 and the polymer concentration is 60% by mass is assumed, it is necessary to make condensation until at least a polymer concentration of 75% by mass (polymer 6 parts by mass: solvent 2 parts by mass) and thereafter add 2 parts by mass of another solvent and stir the resultant for homogenization, and such a high concentration increases the probability of causing precipitation of a large amount of the polymer or an increase in viscosity to make stirring impossible.
Resist compositions for thick films tend to be increased in polymer concentration and viscosity, and polymer solutions before addition of acid generators and additives also tend to be demanded to be correspondingly high in polymer concentration. There is a need for a method for efficiently producing a polymer solution having a high polymer concentration and containing a mixed solvent.
Accordingly, an object of the present invention is to provide a method for efficiently producing a polymer solution which is suitable for preparation of a resist composition, in particular, a resist composition for thick films, which has a high polymer concentration, and which contains a plurality of solvents at a desired ratio.

Solution to Problem

The present inventors have made intensive studies, and as a result, have found that the above problems can be solved by carrying out a first condensation step, a prepolymer solution preparation step, and a second condensation step, described below in detail, in the listed order in a method for producing a polymer solution containing a polymer in a mixed solvent of at least two or more solvents mixed at a predetermined mass ratio.
Specifically, the present invention provides the following invention.

[1] A method for producing a polymer solution containing C% by mass of a polymer in a mixed solvent of at least two or more solvents mixed at a predetermined mass ratio, the method comprising the following steps:

a first condensation step: a step of condensing a solution of the polymer dissolved in at least one solvent of the mixed solvent so that a polymer concentration of Cz ($0.8C < Cz \leq C + 10$) % by mass is achieved,
a prepolymer solution preparation step: a step of adding the solvents used in the mixed solvent to the polymer solution obtained in the first condensation step, to prepare a prepolymer solution, in which
the prepolymer solution is a solution containing the polymer at a concentration of Ck ($0.3C \leq Ck \leq 0.8C$) % by mass in the mixed solvent, in which, when the prepolymer solution is condensed from a polymer concentration of Ck% by mass to a polymer concentration of C% by mass, a mass ratio between the at least two or more solvents of the

mixed solvent is within ±5% of the predetermined mass ratio, and
a second condensation step: a step of condensing the prepolymer solution to a polymer concentration of C% by mass.

[2] The method for producing a polymer solution according to [1], wherein a mass ratio of each of the solvents in the prepolymer solution is determined by the following preliminary test:
(Procedure of preliminary test)

a polymer concentration of Ck of the prepolymer solution is set, and a degree R of solvent condensation {= (100 - C)/(100 × C/Ck - C)} in the case of condensation of the prepolymer solution in the second condensation step is calculated, and
subsequently, a mixed solvent in which a composition ratio of a solvent considered to be more distilled off during distillation with reference to a boiling point and a vapor pressure of each of the solvents is higher than a target composition ratio is prepared, and distilled until a total mass of the mixed solvent is decreased to a value obtained by multiplication with the degree R of solvent condensation, and determining a solvent composition ratio after distillation, and a mixed solvent composition ratio allowing the solvent composition ratio after distillation to be equal to the target composition ratio is determined and the mixed solvent composition ratio is defined as the mass ratio of each of the solvents in the prepolymer solution.

[3] The method for producing a polymer solution according to [1] or [2], further comprising a solvent replacement step: a step of adding at least one solvent of the mixed solvent to the polymer-containing solution and at the same time distilling the solvent under reduced pressure, to decrease any other low-boiling point impurities than the solvent, before the first condensation step.
[4] The method for producing a polymer solution according to any of [1] to [3], further comprising
a component adjustment step: a step of adding a solvent to the polymer solution to modulate a polymer concentration and a mixed solvent composition ratio, after the second condensation step.
[5] The method for producing a polymer solution according to any of [1] to [4], wherein the polymer concentration C in the polymer solution is 30 to 70% by mass.
[6] The method for producing a polymer solution according to any of [1] to [5], wherein a concentration of a first solvent is 45% by mass or more and less than 80% by mass and a concentration of a second solvent is 20% by mass or more and 50% by mass or less based on a total mass of the mixed solvent of the polymer solution.
[7] The method for producing a polymer solution according to any of [1] to [6], wherein the polymer is a polymer for resist and the mixed solvent is a solvent for resist.

## Advantageous Effect of the Invention

According to the present invention, a polymer solution can be efficiently produced on a commercial scale, the polymer solution being suitable for preparation of a resist composition, in particular, a resist composition for thick films, having a high polymer concentration, and containing a plurality of solvents at a desired ratio.

## DESCRIPTION OF EMBODIMENTS

### [Polymer]

The type of a polymer to which the present invention is applied is not limited, and the present invention relates to a method suitable for sufficiently producing a resist polymer solution useful for preparation of a photoresist composition, and can be applied to any conventionally known polymer for resist without any particular limitations. A polymer for resist, described below in detail, is preferably used as the polymer in the present invention.

### [Polymer for resist]

The polymer for resist is a polymer to be changed in solubility in a developer due to the action of acid, and has at least one repeating unit (A) having a structure in which an alkali-soluble group is protected with an acid-dissociable dissolution-inhibitive group. The acid-dissociable dissolution-inhibitive group refers to a group which not only inhibits the polymer from being dissolved in an alkaline developer, but also is dissociated due to the action of acid to allow the polymer to be dissolved in the alkaline developer. The polymer may contain, for example, a repeating unit (B) having a lactone ring structure and/or a repeating unit (C) having a hydroxy group in order to enhance adhesiveness of the polymer to a substrate. The polymer can, if necessary, further contain any other repeating unit such as a repeating unit (D) having a

structure not only suppressing dissolution in the alkaline developer, but also being stable against the action of acid (hereinafter, sometimes referred to as "acid-stable dissolution-inhibitive structure").

(Repeating unit (A))

The repeating unit (A) is a repeating unit having a structure in which an alkali-soluble group such as a carboxyl group, a phenolic hydroxyl group, or a sulfonic acid group is protected with an acid-dissociable dissolution-inhibitive group to be dissociated due to the action of acid. The repeating unit is preferably a repeating unit in which a carboxyl group or an OH group such as a phenolic hydroxyl group or a sulfonic acid group in a repeating unit derived from (meth)acrylic acid, hydroxystyrene or the like is protected with the acid-dissociable dissolution-inhibitive group.

Examples of the acid-dissociable dissolution-inhibitive group can include a structure represented by formula (a1) or (a2).

[Formula 1]

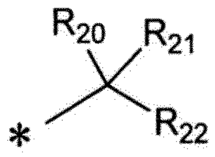

(a1)

In the formula (a1), * represents a binding site in the formula (a1), $R_{20}$ and $R_{21}$ each independently represent a hydrocarbon group having 1 to 4 carbon atoms, and specific examples thereof can include alkyl groups each having 1 to 4 carbon atoms, such as a methyl group, an ethyl group, a n-propyl group, an i-propyl group, a n-butyl group, and an i-butyl group. $R_{22}$ represents a hydrocarbon group having 1 to 12 carbon atoms, and specific examples thereof can include linear, branched or cyclic alkyl groups each having 1 to 12 carbon atoms, such as a methyl group, an ethyl group, a n-propyl group, an i-propyl group, a n-butyl group, an i-butyl group, a cyclopentyl group, a cyclohexyl group, a norbornyl group, a tricyclo[5.2.1.02,6]decanyl group, an adamantyl group, and a tetracyclo[4.4.0.12,5.17,10]dodecanyl group, and aryl groups each having 6 to 12 carbon atoms, such as a phenyl group and a naphthyl group. Here, $R_{22}$ is optionally bonded with $R_{20}$ or $R_{21}$ to form a ring, specifically, an alicyclic ring having 5 to 12 carbon atoms, such as a cyclopentane ring, a cyclohexane ring, a norbornane ring, a tricyclo[5.2.1.02,6]decane ring, an adamantane ring, or a tetracyclo[4.4.0.12,5.17,10]dodecane ring. In particular, when $R_{22}$ contains, or $R_{22}$ is bonded with $R_{20}$ or $R_{21}$ to form a saturated alicyclic ring, specifically, a cyclopentane ring, a cyclohexane ring, a norbornane ring, a tricyclo[5.2.1.02,6]decane ring, an adamantane ring, a tetracyclo[4.4.0.12,5.17,10]dodecane ring, or the like, the difference between the solubility in the alkaline developer before lithography and that after lithography is large and such a large difference is preferred for drawing a fine pattern.

[Formula 2]

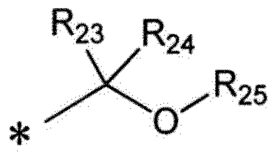

(a2)

In the formula (a2), * represents a binding site in the formula (a2), $R_{23}$ and $R_{24}$ each independently represent a hydrogen atom or a hydrocarbon group having 1 to 4 carbon atoms, and specific examples thereof can include a hydrogen atom, and alkyl groups each having 1 to 4 carbon atoms, such as a methyl group, an ethyl group, a n-propyl group, an i-propyl group, a n-butyl group, and an i-butyl group. $R_{25}$ represents a hydrocarbon group having 1 to 12 carbon atoms, and specific examples thereof can include linear, branched or cyclic alkyl groups each having 1 to 12 carbon atoms, such as a methyl group, an ethyl group, a n-propyl group, an i-propyl group, a n-butyl group, an i-butyl group, a t-butyl group, a 2-ethylhexyl group, a cyclopentyl group, a cyclohexyl group, a norbornyl group, a tricyclo[5.2.1.02,6]decanyl group, an adamantyl group, and a tetracyclo[4.4.0.12,5.17,10]dodecanyl group. Here, $R_{23}$ is optionally bonded with $R_{24}$ or $R_{25}$ to form a ring, and specific examples of a ring in which $R_{23}$ is bonded with $R_{24}$ can include a cyclopentane ring, a cyclohexane ring, a norbornane ring, a tricyclo[5.2.1.02,6]decane ring, an adamantane ring, and a tetracyclo[4.4.0.12,5.17,10]dodecane ring and specific examples of a ring in which $R_{23}$ is bonded with $R_{25}$ can include a hydrofuran ring and a hydropyran ring.

Specific examples of the repeating unit (A) are listed below, but do not limit the present invention. One, or a plurality of types different in structure can be selected from such repeating units (A), and then used.

[Formula 3]

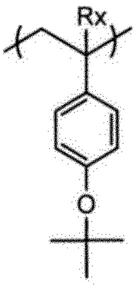
(A101)

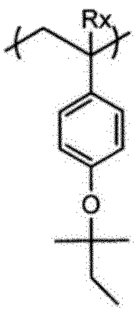
(A102)

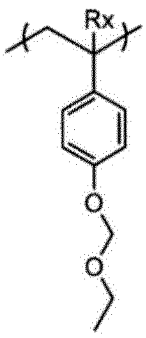
(A103)

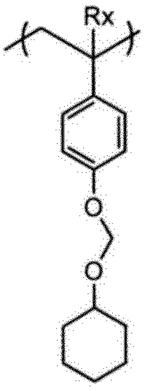
(A104)

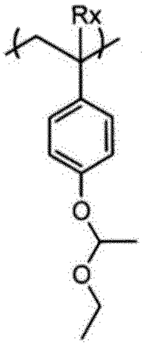
(A105)

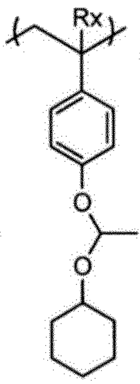
(A106)

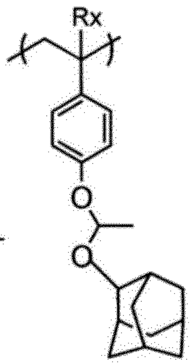
(A107)

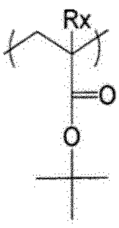
(A201)

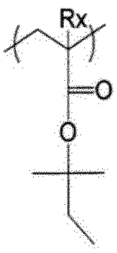
(A202)

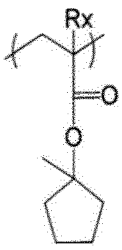
(A203)

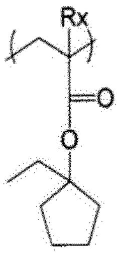
(A204)

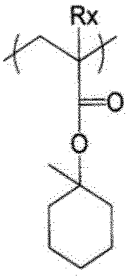
(A205)

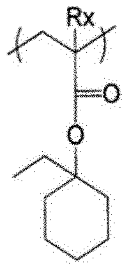
(A206)

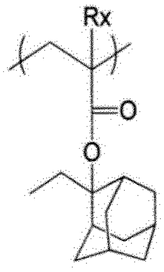
(A207)

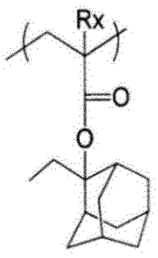
(A208)

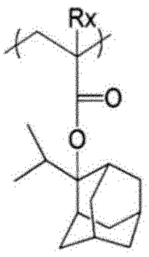
(A209)

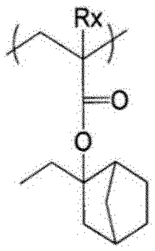
(A210)

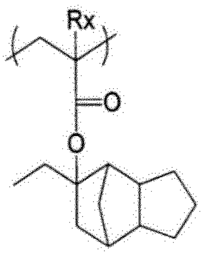
(A211)

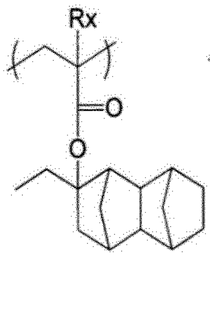

(A212)

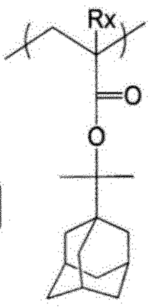

(A213)

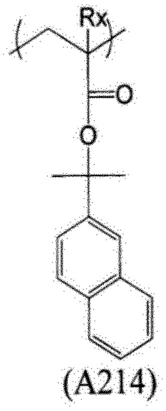

(A214)

(wherein $R_x$ represents H, $CH_3$ or $CF_3$.)

[Formula 4]

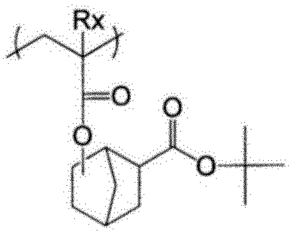

(A301)

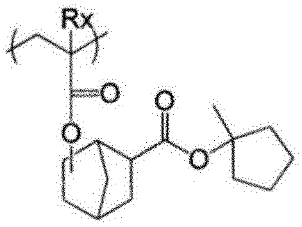

(A302)

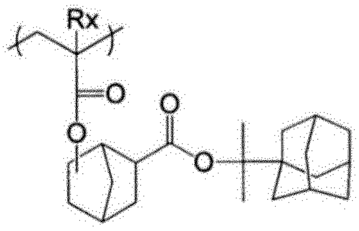

(A303)

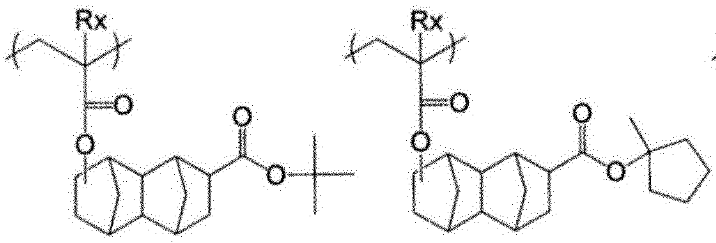

(A304)

(A305)

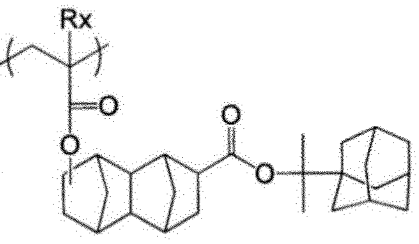

(A306)

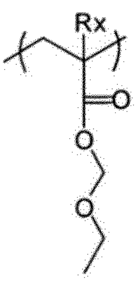

(A401)

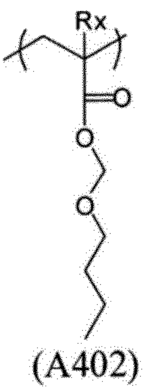

(A402)

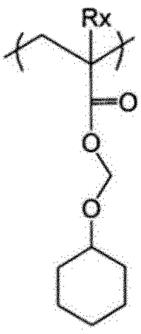

(A403)

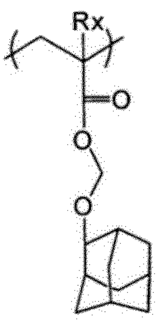

(A404)

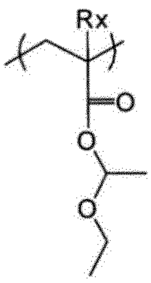

(A405)

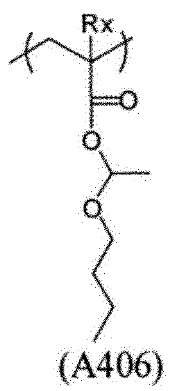

(A406)

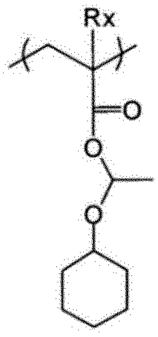
(A407)

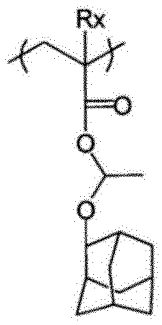
(A408)

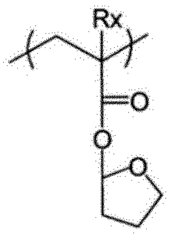
(A409)

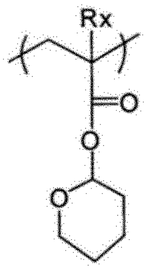
(A410)

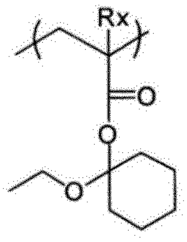
(A411)

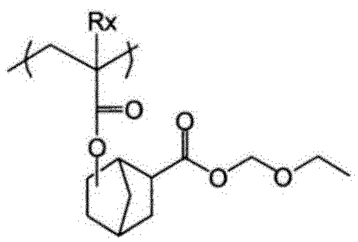
(A412)

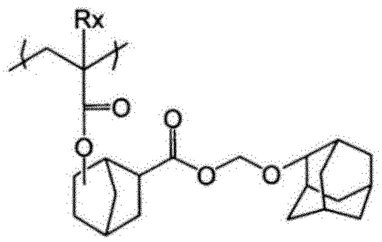
(A413)

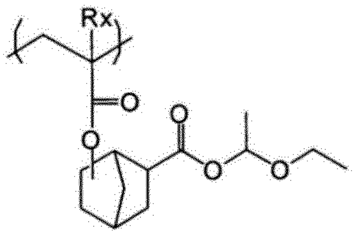
(A414)

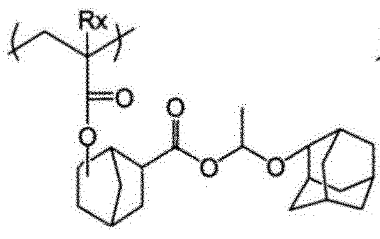
(A415)

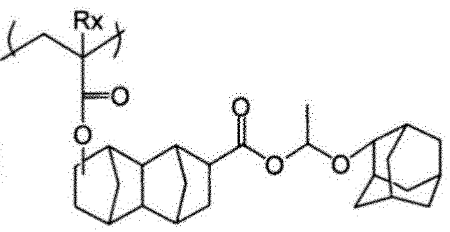
(A416)

(wherein $R_x$ represents H, $CH_3$ or $CF_3$.)

(Repeating unit (B))

The repeating unit (B) is a repeating unit having a lactone structure or a sultone structure, and serves to enhance adhesiveness to a substrate and/or an underlying film, and/or control solubility in a lithographic solvent and/or an alkaline developer. Preferred examples can include a structure represented by formula (B1).

[Formula 5]

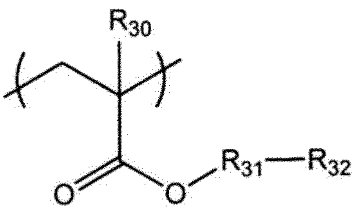
(B1)

In the formula (B1), $R_{30}$ represents a hydrogen atom, or a hydrocarbon group having 1 to 4 carbon atoms optionally substituted with a fluorine atom, specific examples thereof can include a hydrogen atom, and alkyl groups each having 1 to 4 carbon atoms, such as a methyl group, an ethyl group, a n-propyl group, an i-propyl group, a n-butyl group, an i-butyl group, and a trifluoromethyl group, and preferred is a hydrogen atom, a methyl group, or a trifluoromethyl group. $R_{31}$

represents a single bond or a divalent linkage group. The divalent linkage group represents an alkylene group having 1 to 4 carbon atoms or a group in which the alkylene group is substituted with an oxygen atom, a carbonyl group, or a carbonyloxy group. $R_{32}$ represents a lactone structure-containing group represented by formula (b).

[Formula 6]

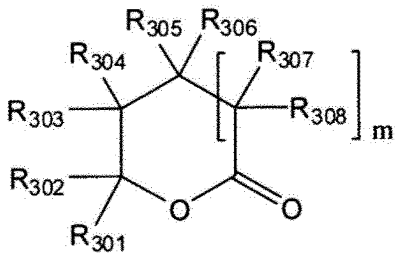

(b)

In the formula (b), any one of $R_{301}$ to $R_{308}$ represents a single bond being a binding site serving as $R_{32}$ and the balance of $R_{301}$ to $R_{308}$ represents a hydrogen atom, or a hydrocarbon group or an alkoxy group having 1 to 4 carbon atoms, or any one of $R_{301}$ to $R_{308}$ represents a hydrocarbon group containing optionally an oxygen atom or a sulfur atom and having 3 to 14 carbon atoms, the group having a binding site serving as $R_{32}$ and being bonded with any one or two of other $R_{301}$ to $R_{308}$ to form an alicyclic ring having 5 to 15 carbon atoms, and any one or two of the balance of $R_{301}$ to $R_{308}$ represent a single bond for forming the alicyclic ring having 5 to 15 carbon atoms and other $R_{301}$ to $R_{308}$ represent a hydrogen atom, or a hydrocarbon group or an alkoxy group having 1 to 4 carbon atoms. m represents an integer of 0 or 1.

Examples of the alicyclic ring include a cyclopentane ring, a cyclohexane ring, a norbornane ring, a 7-oxa-norbornane ring, a 7-thia-norbornane ring, and a tetracyclo[4.4.0.12,5.17,10]dodecane ring, preferably, a norbornane ring and a 7-oxa-norbornane ring. Specific examples of the hydrocarbon group having 1 to 4 carbon atoms can include a methyl group, an ethyl group, a n-propyl group, an i-propyl group, a n-butyl group, and an i-butyl group, and specific examples of the alkoxy group having 1 to 4 carbon atoms can include a methoxy group and an ethoxy group.

Particularly preferred examples of a lactone structure in which any one of $R_{301}$ to $R_{308}$ represents a single bond being a binding site serving as $R_{32}$ and the balance of $R_{301}$ to $R_{308}$ represents a hydrogen atom, or a hydrocarbon group or an alkoxy group having 1 to 4 carbon atoms in the formula (b) can include a $\gamma$-butyrolactone structure and a $\delta$-valerolactone structure. Particularly preferred examples of a lactone structure in which any one of $R_{301}$ to $R_{308}$ represents a hydrocarbon group containing optionally an oxygen atom or a sulfur atom and having 3 to 14 carbon atoms, the group having a binding site serving as $R_{32}$ and being bonded with any one or two of other $R_{301}$ to $R_{308}$ to form an alicyclic ring having 5 to 15 carbon atoms, and the balance of $R_{301}$ to $R_{308}$ represents a hydrogen atom, or a hydrocarbon group or an alkoxy group having 1 to 4 carbon atoms can include a 1,3-cyclohexanecarbolactone structure, a 2,6-norbornanecarbolactone structure, a 7-oxa-2,6-norbornanecarbolactone structure, and a 4-oxa-tricyclo[5.2.1.02,6]decan-3-one structure.

Specific examples of the repeating unit (B) are listed below, but do not limit the present invention. One or a plurality of types different in structure, can be selected from such repeating units (B) and then used.

[Formula 7]

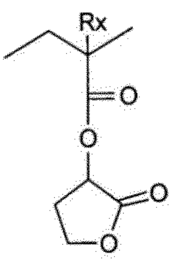
(B101)

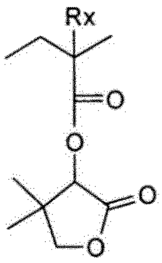
(B102)

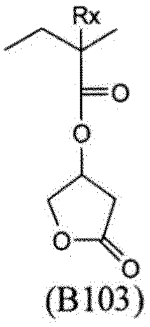
(B103)

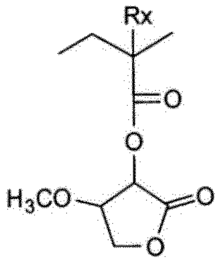
(B104)

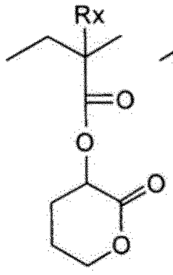
(B105)

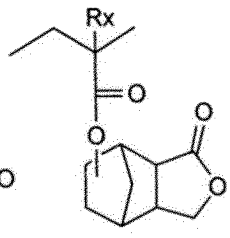
(B106)

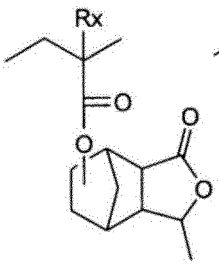
(B107)

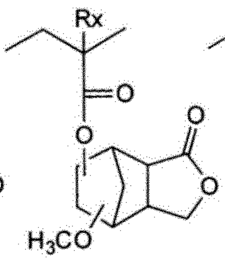
(B108)

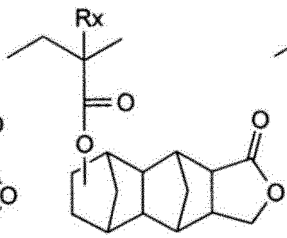
(B109)

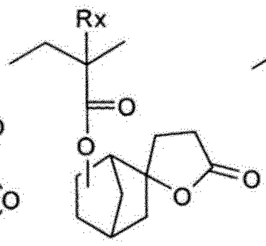
(B110)

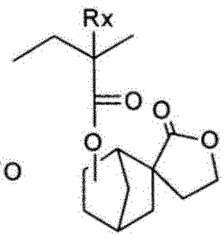
(B111)

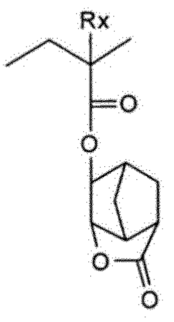
(B112)

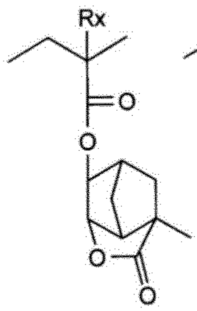
(B113)

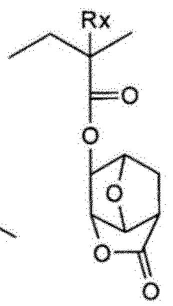
(B114)

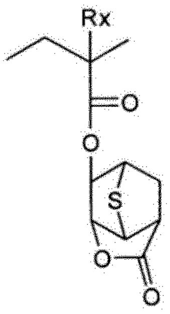
(B115)

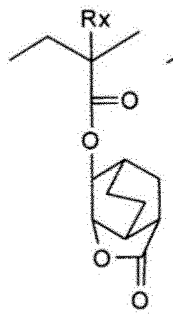
(B116)

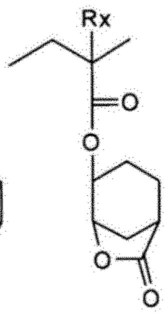
(B117)

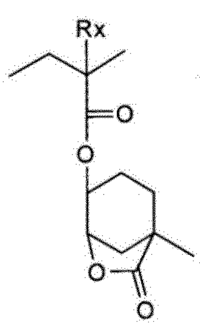
(B118)

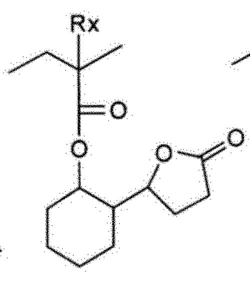
(B119)

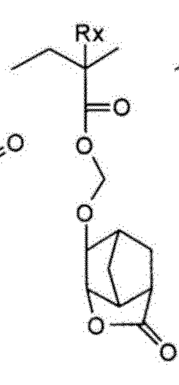
(B201)

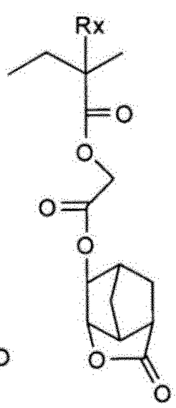
(B202)

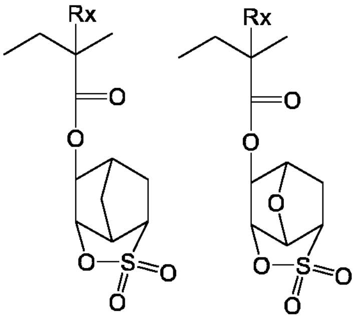 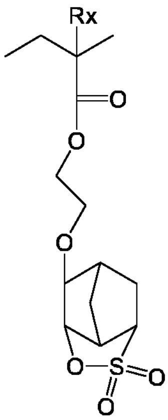 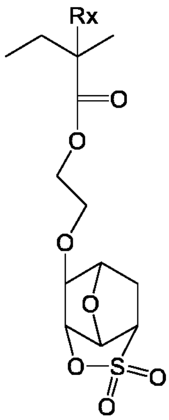 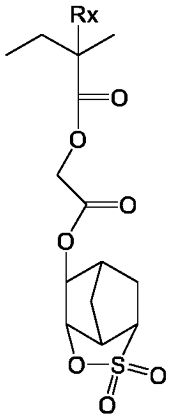 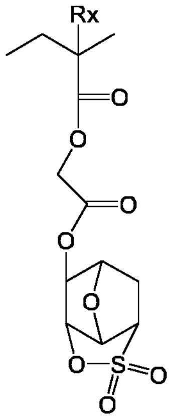

(B301) (B302) (B303) (B304) (B305) (B306)

(wherein $R_x$ represents H, $CH_3$, or $CF_3$.)

(Repeating unit (C))

The repeating unit (C) is a repeating unit having a hydroxy group or a carboxy group in a side chain, and serves to enhance adhesiveness of the polymer to a substrate and/or an underlying film, control solubility in a lithographic solvent and/or an alkaline developer, and/or react with a curing agent to form a crosslinked structure.

The structure of the repeating unit (C) is particularly preferably any structure represented by formulae (C1) to (C3).

[Formula 8]

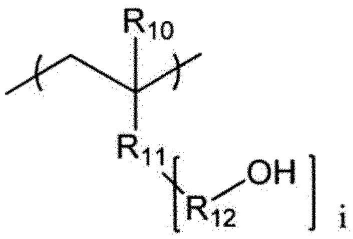

(C1)

In the formula (C1), $R_{10}$ represents a hydrogen atom, or a hydrocarbon group having 1 to 4 carbon atoms optionally substituted with a fluorine atom, specific examples thereof can include a hydrogen atom, and alkyl groups each having 1 to 4 carbon atoms optionally substituted with a fluorine atom, such as a methyl group, an ethyl group, a n-propyl group, an i-propyl group, a n-butyl group, an i-butyl group, and a trifluoromethyl group, and preferred is a hydrogen atom, a methyl group, or a trifluoromethyl group. $R_{11}$ represents a substituted or unsubstituted aromatic hydrocarbon group. $R_{12}$ represents a single bond, a divalent hydrocarbon group having 1 to 4 carbon atoms optionally substituted with a fluorine atom, or a carbonyl group, specific examples thereof can include a single bond, and alkylene groups each having 1 to 4 carbon atoms optionally substituted with a fluorine atom, such as a methylene group, a 1,1-ethylene group, a 2,2-propylene group, a 1,1,1,3,3,3-hexafluoro-2,2-propylene group, and a 1,1,1-trifluoro-2-trifluoromethyl-2,3-propylene group, and preferred is a single bond, a 1,1,1,3,3,3-hexafluoro-2,2-propylene group, or a 1,1,1-trifluoro-2-trifluoromethyl-2,3-propylene group and particularly preferred is a single bond. i represents an integer of 1 or 2.

[Formula 9]

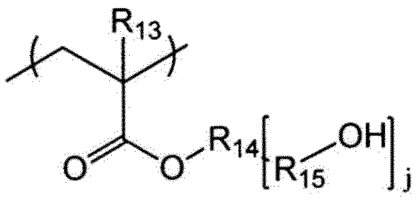

( C2 )

In the formula (C2), $R_{13}$ represents a hydrogen atom, or a hydrocarbon group having 1 to 4 carbon atoms optionally substituted with a fluorine atom, specific examples thereof can include a hydrogen atom, and alkyl groups each having 1 to 4 carbon atoms optionally substituted with a fluorine atom, such as a methyl group, an ethyl group, a n-propyl group, an i-propyl group, a n-butyl group, an i-butyl group, and a trifluoromethyl group, and preferred is a hydrogen atom, a methyl group, or a trifluoromethyl group. $R_{14}$ represents a di- to tetravalent hydrocarbon group containing optionally a fluorine atom, an oxygen atom or a sulfur atom and having 2 to 20 carbon atoms, and specific examples thereof can include linear or branched saturated hydrocarbon groups each having 2 to 6 carbon atoms, such as an ethylene group and an isopropylene group, alicyclic groups each containing optionally an oxygen atom or a sulfur atom and having 5 to 20 carbon atoms, such as a cyclohexane ring, a norbornane ring, a 7-oxa-norbornane ring, a 7-thia-norbornane ring, an adamantane ring, and a tetracyclo[4.4.0.12,5.17,10]dodecane ring, and aromatic groups each having 6 to 20 carbon atoms, such as a benzene ring, a naphthalene ring, an anthracene ring, a phenanthrene ring, and biphenyl. Preferred is a cyclohexane ring, a norbornane ring, an adamantane ring, or a benzene ring. $R_{15}$ represents a single bond, or a divalent hydrocarbon group having 1 to 4 carbon atoms optionally substituted with a fluorine atom, specific examples thereof can include a single bond, and alkylene groups each having 1 to 4 carbon atoms optionally substituted with a fluorine atom, such as a methylene group, a 1,1-ethylene group, a 2,2-propylene group, a 1,1,1,3,3,3-hexafluoro-2,2-propylene group, and a 1,1,1-trifluoro-2-trifluoromethyl-2,3-propylene group, and preferred is a single bond, a 1,1,1,3,3,3-hexafluoro-2,2-propylene group, or a 1,1,1-trifluoro-2-trifluoromethyl-2,3-propylene group. j represents an integer of 1 to 3.

[Formula 10]

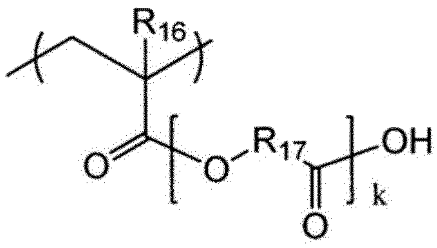

( C3 )

In the formula (C3), $R_{16}$ represents a hydrogen atom, or a hydrocarbon group having 1 to 4 carbon atoms optionally substituted with a fluorine atom, specific examples thereof can include a hydrogen atom, and alkyl groups each having 1 to 4 carbon atoms optionally substituted with a fluorine atom, such as a methyl group, an ethyl group, a n-propyl group, an i-propyl group, a n-butyl group, an i-butyl group, and a trifluoromethyl group, and preferred is a hydrogen atom, a methyl group, or a trifluoromethyl group. $R_{17}$ represents a divalent alicyclic hydrocarbon group containing optionally an oxygen atom or a sulfur atom and having 6 to 12 carbon atoms, specific examples thereof can include alicyclic hydrocarbon groups each having a norbornane ring, a 7-oxa-norbornane ring, a 7-thia-norbornane ring, or a tetracyclo [4.4.0.12,5.17,10]dodecane ring and optionally containing an oxygen atom or a sulfur atom, and preferred is a norbornane ring or a tetracyclo[4.4.0.12,5.17,10]dodecane ring. k represents an integer of 0 or 1.

Specific examples of the repeating unit (C) are listed below, but do not limit the present invention. One or a plurality of types different in structure, can be selected from such repeating units (C) and then used.

[Formula 11]

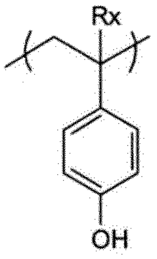

(C101)

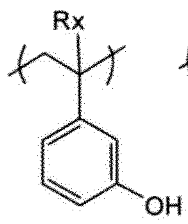

(C102)

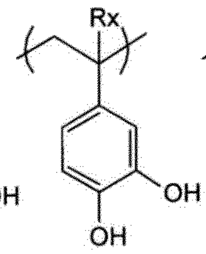

(C103)

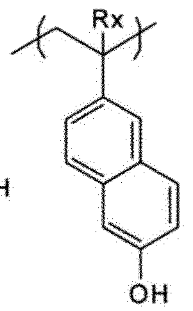

(C104)

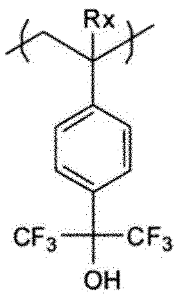

(C105)

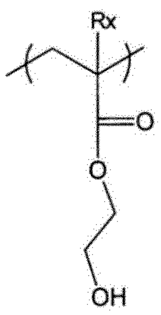

(C201)

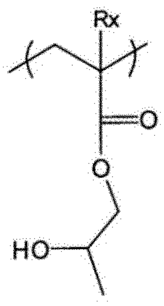

(C202)

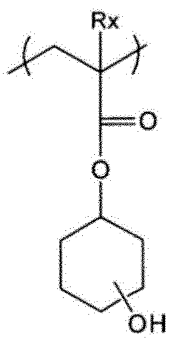

(C203)

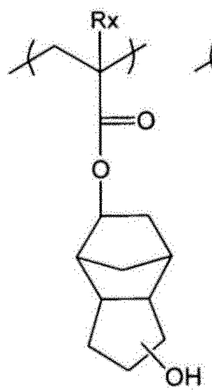

(C204)

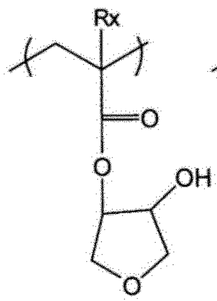

(C205)

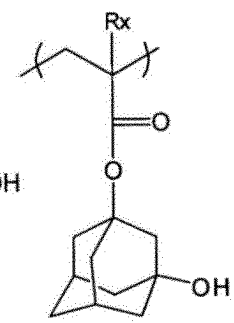

(C206)

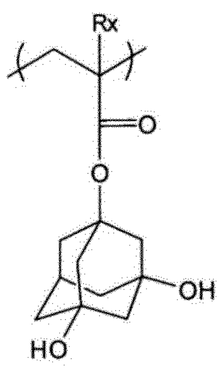

(C207)

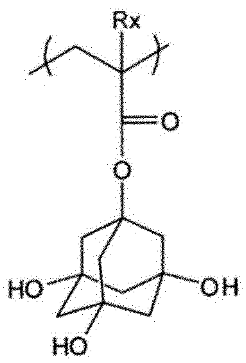

(C208)

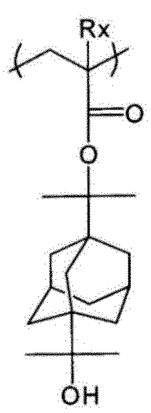

(C209)

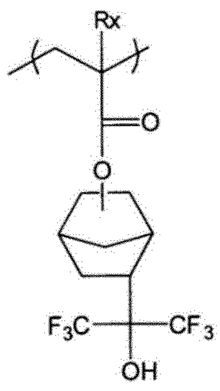

(C210)

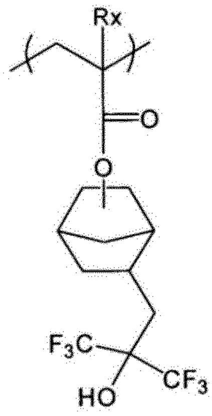

(C211)

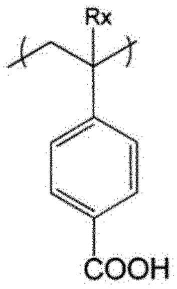
(C301)

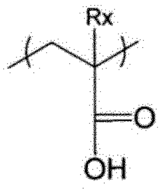
(C302)

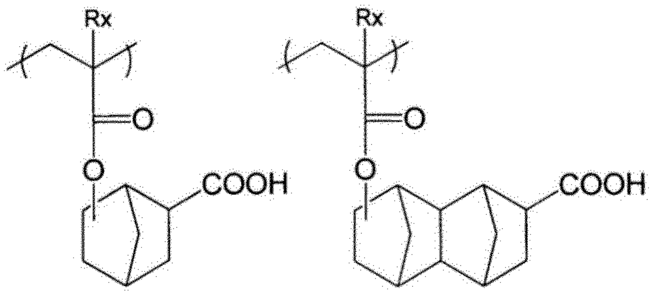
(C303) (C304)

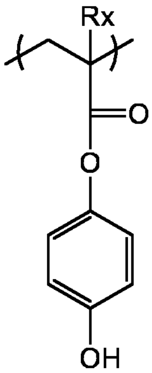
(C401)

(wherein $R_x$ represents H, $CH_3$, or $CF_3$.)

(Repeating unit (D))

The repeating unit (D) is a repeating unit having a structure in which an alkali-soluble group such as a carboxyl group or a phenolic hydroxyl group is protected with an acid-stable dissolution-inhibitive group not to be dissociated even due to the action of acid. The repeating unit is preferably a repeating unit in which a carboxyl group or a phenolic hydroxyl group in a repeating unit derived from (meth)acrylic acid, hydroxystyrene or the like is protected with the acid-stable dissolution-inhibitive group. The repeating unit serves to control solubility in a lithographic solvent and/or an alkaline developer, and optical characteristics of a thin film, such as a refractive index and light transmittance.

Examples of the acid-stable dissolution-inhibitive group include an aliphatic hydrocarbon group having 1 to 12 carbon atoms, an aromatic hydrocarbon group, or a structure in which a methyl group and a 1-adamantyl group are bonded, wherein carbon substituting for a hydrogen atom in a carboxyl group or a phenolic hydroxyl group and bonding with an oxygen atom is primary or secondary carbon. Specific examples can include a methyl group, an ethyl group, a n-propyl group, an i-propyl group, a n-butyl group, an i-butyl group, a cyclopentyl group, a cyclohexyl group, a 2-norbornyl group, a 2-isobornyl group, an 8-tricyclo[5.2.1.02,6]decanyl group, a 1-adamantyl group, a 2-adamantyl group, a 4-tetracyclo[4.4.0.12,5.17,10]dodecanyl group, a phenyl group, a benzyl group, a naphthyl group, and an anthracenyl group.

Specific examples of the repeating unit (D) are listed below, but do not limit the present invention. One or a plurality of types different in structure can be selected from such repeating units (D) and then used.

[Formula 12]

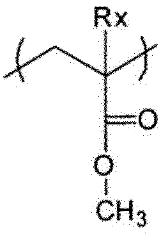
(D101)

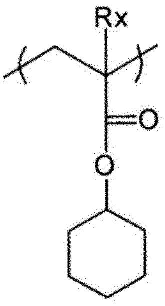
(D102)

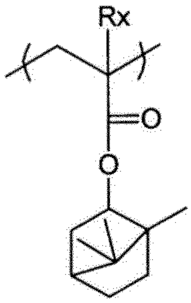
(D103)

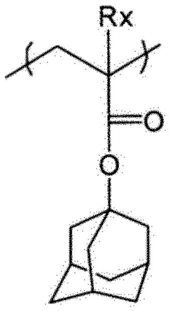
(D104)

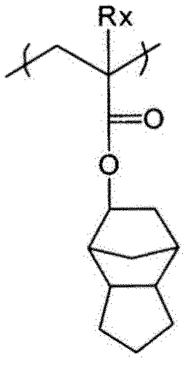
(D105)

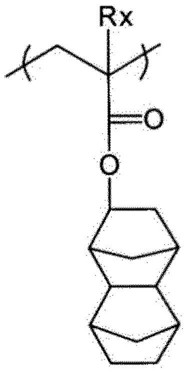
(D106)

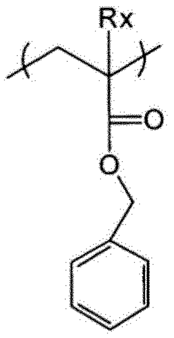
(D107)

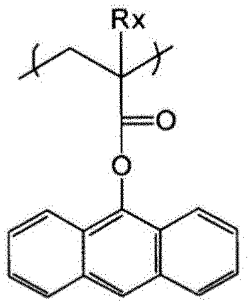
(D108)

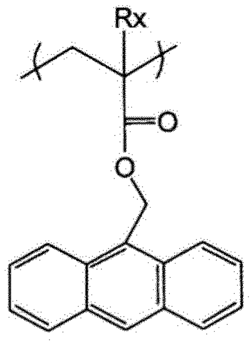
(D109)

(wherein $R_x$ represents H, $CH_3$, or $CF_3$.)

Examples of a repeating unit having the same effect as that of the repeating unit (D) can include a repeating unit represented by formula (D').

[Formula 13]

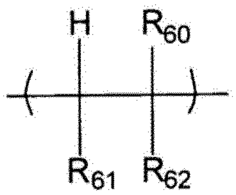
( D' )

In the formula (D'), $R_{60}$ represents a hydrogen atom, or a hydrocarbon group having 1 to 4 carbon atoms optionally substituted with a fluorine atom, specific examples thereof can include a hydrogen atom, and alkyl groups each having 1 to 4 carbon atoms optionally substituted with a fluorine atom, such as a methyl group, an ethyl group, a n-propyl group, an i-propyl group, a n-butyl group, an i-butyl group, and a trifluoromethyl group, and preferred is a hydrogen atom, a methyl group, or a trifluoromethyl group. $R_{61}$ represents a hydrogen atom, a single bond bonded with $R_{62}$ or an alkylene group having 1 to 4 carbon atoms, and specific examples thereof can include a hydrogen atom, a single bond, a methylene group, an ethylene group, and an isopropylene group. $R_{62}$ represents an aromatic hydrocarbon group having 6 to 14 carbon atoms, and specific examples thereof can include a benzene ring, a naphthalene ring, and an anthracene ring.

Specific examples of the repeating unit (D') are listed below.

[Formula 14]

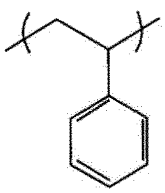
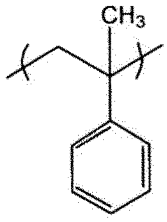
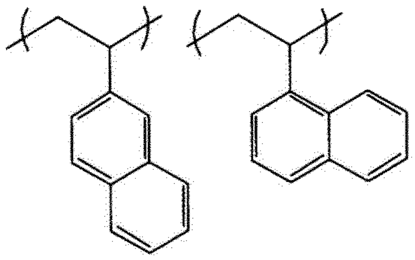
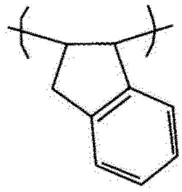
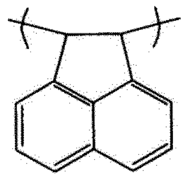

(D'101) (D'102) (D'203) (D'204) (D'205) (D'206)

(Weight average molecular weight and molecular weight distribution)

The weight average molecular weight (Mw) and molecular weight distribution (Mw/Mn) of the polymer are not particularly limited, and can be appropriately set depending on the intended use. In the case of a resist polymer, the weight average molecular weight (Mw) is, for example, 1,000 to 100,000, and the molecular weight distribution (Mw/Mn) is, for example, 1.1 or more and 5.0 or less.

In the present invention, the weight average molecular weight (Mw) and the molecular weight distribution (Mw/Mn) of the polymer are measurement values by GPC (gel permeation chromatography), and can be measured under measurement conditions described below.

[Method for producing polymer solution]

The method for producing a polymer solution of the present invention includes a first condensation step, a prepolymer solution preparation step, and a second condensation step. The method may further include a component adjustment step after the second condensation step. The method for producing a polymer solution of the present invention may further include a solvent replacement step and/or a filtration step, before the first condensation step. The method for producing a polymer solution may further include a polymerization step, before the solvent replacement step, and/or may further include a purification step, after the polymerization step. According to a particularly preferred aspect of the present invention, the method for producing a polymer solution includes the polymerization step, the purification step, the solvent replacement step, the first condensation step, the prepolymer solution preparation step, and the second condensation step in the listed order.

[Polymerization step]

Examples of the polymerization method for polymer formation include known polymerization methods such as a solution polymerization method, an emulsion polymerization method, a suspension polymerization method, and a mass polymerization method. In particular, a solution polymerization method is preferred in the case of production of a polymer for resist, and can be carried out with reference to many literature relating to known polymerization methods for resist polymer formation.

Examples include a lump heating method including dissolving a monomer, together with a polymerization initiator, in a solvent and directly heating and polymerizing the monomer, and a dropping polymerization method including dropping a monomer and a polymerization initiator into a solvent heated, to polymerize the monomer. Examples of the dropping polymerization method include a mixing and dropping method including dissolving a monomer, together with a polymerization initiator, if necessary, in a solvent and dropping the monomer into a solvent heated, to polymerize the monomer, and an independent dropping method including separately dissolving a monomer and a polymerization initiator, if necessary, in a solvent, and separately dropping the monomer and the polymerization initiator into a solvent heated, to polymerize the monomer. In the present invention, a dropping polymerization method is preferred.

Here, the lump heating method and the mixing and dropping method allow the monomer at a high concentration to have an opportunity to contact with radical at a low concentration respectively in a polymerization system and in a dropping liquid storage tank before dropping into a polymerization system, and therefore tend to generate a high-molecular weight product (highpolymer) having a molecular weight of 100000 or more, the product being one cause of the occurrence of pattern defects. On the other hand, the independent dropping method is particularly preferred as the polymerization method in the present invention because the polymerization initiator and the monomer do not coexist in the

dropping liquid tank and the monomer, even when dropped into the polymerization system, is kept at a low concentration and therefore the highpolymer is hardly generated. Here, not only the dropping time, but also the composition ratio of the monomer to be dropped, the composition ratio among the monomer, the polymerization initiator and the chain transfer agent, and the like may be modified in the mixing and dropping method and the independent dropping method.

The polymerization initiator here used can be conventionally known one. A polymerization initiator for radical polymerization is preferably, for example, a radical polymerization initiator such as an azo compound or peroxide. Specific examples of such a polymerization initiator being an azo-based compound can include 2,2'-azobisisobutyronitrile, 2,2'-azobis(2-methylbutyronitrile), dimethyl2,2'-azobis(2-methylpropionate), 1,1'-azobis(cyclohexane-1-carbonitrile), and 4,4'-azobis(4-cyanovaleric acid). Examples of such a polymerization initiator being peroxide can include decanoyl peroxide, lauroyl peroxide, benzoyl peroxide, bis(3,5,5-trimethylhexanoyl)peroxide, succinic acid peroxide, tert-butyl peroxy-2-ethylhexanoate, tert-butyl peroxypivalate, and 1,1,3,3-tetramethylbutyl peroxy-2-ethylhexanoate. These can be used singly or as a mixture thereof. Such a polymerization initiator being an azo-based compound is more preferred because of being excellent in handling safety. The amount of the polymerization initiator used can be selected depending on an objective molecular weight, the types of the monomer, the polymerization initiator, the chain transfer agent, the solvent, and the like, the composition ratio of the repeating units, the polymerization temperature, the dropping rate, and the like.

The polymerization initiator is preferably dissolved in an organic solvent and then added into the polymerization system. The organic solvent dissolving the polymerization initiator is not particularly limited as long as it dissolves the polymerization initiator. Specific examples can include ketones such as acetone, methyl ethyl ketone, methyl isobutyl ketone, methyl isoamyl ketone, methyl amyl ketone and cyclohexanone, alcohols such as methanol, ethanol and isopropanol, ether alcohols such as ethylene glycol monomethyl ether, ethylene glycol monoethyl ether, propylene glycol monomethyl ether and propylene glycol monoethyl ether, ether esters such as ethylene glycol monomethyl ether acetate, ethylene glycol monoethyl ether acetate, propylene glycol monomethyl ether acetate and propylene glycol monoethyl ether acetate, esters such as methyl acetate, ethyl acetate, propyl acetate, isopropyl acetate, butyl acetate, methyl propionate, methyl lactate and ethyl lactate, ethers such as tetrahydrofuran, 1,4-dioxane and ethylene glycol dimethyl ether, aromatic hydrocarbons such as toluene and xylene, N,N-dimethylformamide, and acetonitrile. These solvents may be each used singly, or a plurality of these solvents may be mixed and then used.

A known chain transfer agent can be, if necessary, used as the chain transfer agent. In particular, a thiol compound is preferred, and can be widely selected from known thiol compounds. Specific examples include t-dodecylmercaptan, mercaptoethanol, mercaptoacetic acid, and mercaptopropionic acid. A thiol compound having a structure in which a 2-hydroxy-1,1,1,3,3,3-hexafluoro-2-propyl group is bonded with a saturated aliphatic hydrocarbon is particularly preferred because of having the effect of suppressing roughness and defects of a lithography pattern. The amount of the chain transfer agent used can be selected depending on an objective molecular weight, the types of the monomer, the polymerization initiator, the chain transfer agent, the solvent, and the like, the composition ratio of the repeating units, the polymerization temperature, the dropping rate, and the like.

The monomer in the dropping liquid, and the polymerization initiator, when are by themselves liquids, can also be directly fed without being dissolved in any solvent, and the monomer or the polymerization initiator, when is a viscous liquid or a solid, needs to be dissolved in a solvent and then used. While the concentrations of the monomer and the polymerization initiator are preferably high in terms of productivity, too high concentrations may lead to an increase in solution viscosity and then deterioration in operation ability, or may lead to precipitation, thereby causing time-consuming diffusion in the polymerization system or easily generating a highpolymer in the case of a solid monomer or polymerization initiator. Accordingly, the concentrations are preferably selected so that the monomer and the polymerization initiator, which each have a viscosity in a range causing no problems with feeding operations, are sufficiently dissolved and also are not precipitated and are easily diffused in the polymerization system when fed. The concentrations specifically each differ depending on a combination of a solute and a solvent in each solution, and preparation is usually made so that the total concentration of the entire monomer, and the polymerization initiator concentration are each, for example, in a range of 5 to 60% by mass, preferably 10 to 50% by mass.

A short dropping time in each of the mixing and dropping method and the independent dropping method is not preferred because a molecular weight distribution is easily widened and a large amount of a solution is dropped at one time to cause a decrease in temperature of a polymerization liquid. On the contrary, a long dropping time is not preferred because excess heat history is applied to the polymer, and productivity deteriorates. Accordingly, the dropping time is usually selected from in a range of 0.5 to 24 hours, preferably 1 to 12 hours, particularly preferably 2 to 8 hours.

It is also preferable to maintain the temperature for a certain period or further raise the temperature to perform aging, thereby reacting the remaining unreacted monomer, after completion of dropping and temperature rise to the polymerization temperature in the lump heating method. A too-long aging time is not preferred because the production efficiency per hour deteriorates, and excess heat history is applied to the polymer. Accordingly, the aging time is usually selected from a range of 12 hours or less, preferably 6 hours or less, particularly preferably 1 to 4 hours.

The solvent used in polymerization reaction is not particularly limited as long as it is a solvent capable of stably

dissolving a raw material monomer, the resulting polymer, the polymerization initiator and the chain transfer agent. Specific examples of such a polymerization solvent can include ketones such as acetone, methyl ethyl ketone, methyl isobutyl ketone, methyl isoamyl ketone, methyl amyl ketone and cyclohexanone, alcohols such as methanol, ethanol and isopropanol, ether alcohols such as ethylene glycol monomethyl ether, ethylene glycol monoethyl ether, propylene glycol monomethyl ether and propylene glycol monoethyl ether, esters such as methyl acetate, ethyl acetate, isopropyl acetate, propyl acetate, butyl acetate, methyl propionate, methyl lactate and ethyl lactate, ether esters such as ethylene glycol monomethyl ether acetate, ethylene glycol monoethyl ether acetate, propylene glycol monomethyl ether acetate and propylene glycol monoethyl ether acetate, ethers such as tetrahydrofuran, 1,4-dioxane and ethylene glycol dimethyl ether, aromatic hydrocarbons such as toluene and xylene, N,N-dimethylformamide, and acetonitrile. Preferred are acetone, methyl ethyl ketone, methyl isobutyl ketone, isopropanol, propylene glycol monomethyl ether, methyl acetate, ethyl acetate, isopropyl acetate, propyl acetate, methyl propionate, tetrahydrofuran, 1,4-dioxane, ethylene glycol dimethyl ether, toluene, and acetonitrile, in terms of the solubilities and the boiling points of the monomer, the polymerization initiator, the chain transfer agent and the polymer. These can be used singly or as a mixture of two or more kinds thereof. Alternatively, compounds may be mixed and used which are high in solubilities of the monomer, the polymerization initiator, the chain transfer agent and the polymer and which are high-boiling point compounds, such as ethylene glycol monobutyl ether, 3-methoxy-3-methyl-1-butanol, 3-methoxy-3-methyl-1-butyl acetate, ethyl 3-ethoxypropionate, γ-butyrolactone, diethylene glycol dimethyl ether, N-methylpyrrolidone, and dimethylsulfoxide.

The amount of the polymerization solvent used is not particularly limited, and a too-small amount of the solvent may lead to a monomer precipitated and/or much increased in viscosity, thereby not allowing the polymerization system to be uniformly kept, and a too-large amount of the solvent may lead to insufficient conversion of the monomer and/or no increase in molecular weight of the polymer to a desired value. The amount is usually 0.5 to 20 parts by mass, preferably 1 to 10 parts by mass based on 1 part by mass of the monomer.

The amount of a polymerization solvent initially loaded into a reaction tank (hereinafter, sometimes referred to as "initially loaded solvent") in each of the mixing and dropping method and the independent dropping method may be any amount equal to or more than the minimum amount allowing for stirring, and an excess amount is not preferred because the amount of a monomer solution which can be fed is decreased to cause a reduced production efficiency. The amount is, for example, usually selected from a range of 1/30 or more, preferably 1/20 to 1/2, particularly preferably 1/10 to 1/3 on a volume ratio, based on the amount finally charged (namely, the total amount of the initially loaded solvent, and the monomer solution and an initiator solution dropped). The monomer may be partially mixed with the initially loaded solvent in advance.

The polymerization temperature can be appropriately selected depending on the boiling points of the solvent, the monomer, the chain transfer agent and the like, and the half-life temperature of the polymerization initiator and the like. A low temperature is problematic in terms of productivity because polymerization hardly progresses, and an excessively high temperature is problematic in terms of stability of each of the monomer and the polymer. Accordingly, the polymerization temperature is selected in a range of preferably 40 to 160°C, particularly preferably 60 to 120°C. The polymerization temperature has a large effect on the molecular weight of the polymer and the copolymerization composition ratio and, therefore, needs to be precisely controlled. In this regard, polymerization reaction is generally an exothermic reaction, and the polymerization temperature tends to be raised and, therefore, is difficult to control to a constant temperature. Therefore, it is preferable in the present invention that at least one compound having the boiling point close to a target polymerization temperature be contained as the polymerization solvent and the polymerization temperature be set to a temperature equal to or more than the initial boiling point at the polymerization pressure, of the compound. Such a method can inhibit the polymerization temperature from being raised due to latent heat of vaporization of the polymerization solvent.

The polymerization pressure is not particularly limited, may be normal pressure, increased pressure or reduced pressure, and is usually normal pressure. In the case of radical polymerization, nitrogen gas and oxygen gas are respectively generated in an azo-based system and in a peroxide system during radical generation from the initiator, and therefore such polymerization is preferably performed around atmospheric pressure with the polymerization system as an open system in order to suppress the variation in polymerization pressure.

[Purification step]

The polymer after polymerization reaction contains low-molecular weight impurities, for example, the polymerization solvent, the unreacted monomer, an oligomer, the polymerization initiator, the chain transfer agent, and by-products thereof, and these impurities are preferably removed in a purification step. Specifically, a polymerization reaction liquid is diluted by addition of, if necessary, a good solvent, and then contacted with a poor solvent to precipitate the polymer, and these impurities are extracted into a poor solvent phase (precipitation purification) or extracted into a poor solvent phase as a liquid-liquid twophase. A polymer separated by precipitation purification may be then further washed with a poor solvent. These operations may be made by repeating the same operation or combining different operations.

Examples of the poor solvent used in the purification step include hydroxyl group-containing compounds such as water, methanol, ethanol, isopropanol, ethylene glycol and ethyl lactate, linear, branched or cyclic saturated hydrocarbons such as pentane, n-hexane, iso-hexane, n-heptane, cyclopentane and methylcyclohexane, or aromatic hydrocarbons such as toluene and xylene. These solvents can be each used singly, or can be used as a mixture of two or more kinds thereof. Examples of the good solvent can include solvents exemplified about the polymerization solvent, and solvents exemplified about a solvent for coating film formation described below, and the good solvent and the poor solvent can also be mixed and then used.

The type and the amount of the poor solvent used in the purification step are not particularly limited as long as the polymer can be separated from low-molecular weight compounds, and can be appropriately selected depending on the solubility of the polymer in the poor solvent, the type and the amount of the solvent used in polymerization, the types and the amounts of the impurities, and the like. A small amount of the poor solvent leads to insufficient separation of the impurities such as the polymerization solvent and the unreacted monomer, and on the contrary, a too large amount of the poor solvent leads to an increase of waste and is not preferred in terms of workability and cost. The amount is generally 0.5 to 50 times, preferably 1 to 20 times, further preferably 2 to 10 times on the mass ratio based on the total mass of the polymerization reaction liquid, if necessary, diluted with the good solvent.

The temperature in the purification step has a large effect on, for example, the molecular weight and the molecular weight distribution of the polymer, the rate of removal of impurities such as a remaining monomer and an initiator residue, and furthermore various properties in lithography, and needs to be critically controlled. In the purification step, a too-low temperature is not efficient because solubilities of impurities in a re-precipitation solvent or a washing solvent are insufficient and removal of such impurities is not sufficiently performed, and on the contrary, a toohigh temperature is not preferred because the polymer is eluted in a re-precipitation solvent and a washing solvent to cause the imbalance of the composition ratio in a low molecular weight region of the polymer and/or deterioration in yield. Therefore, the purification step is preferably carried out in a temperature range of 0 to 40°C, preferably in a temperature range of 0 to 30°C.

Any treatment for removal of metal impurities included in the polymer may also be performed. Such a method may be made by washing a solution in which the polymer is dissolved in an organic solvent, with pure water, contacting the solution with an ion-exchange resin, or allowing the solution to flow through a filter having ion-exchange capacity. Such methods may be combined and performed. The ion-exchange resin and the filter having ion-exchange capacity can be those known commercially available for use in the metal removal from a polymer for resist.

[Solvent replacement step]

The solvent replacement step is a step of replacing the solvent of the polymer solution with a solvent used in a resist composition or the like.

The replacement method is performed by heating the polymer solution under reduced pressure to distill off a low-boiling point substance such as the solvent used for purification, and feeding a solvent for resist thereto and at the same time distilling off together the initial solvent and the solvent fed. It is possible to remove low-boiling point impurities, for example, the solvent used for purification, and finish the polymer into a solution for resist.

The temperature of a heat source during heating under reduced pressure is not particularly limited as long as it is a temperature causing no polymer denaturation, and is usually preferably 100°C or less, more preferably 70°C or less, further preferably 60°C or less, particularly preferably 50°C or less. In the solvent replacement step, a low-boiling point component and a solvent for finishing are evaporated under reduced pressure, and therefore, the polymer solution during the step is cooled by heat of vaporization, and the temperature is lower than the temperature of the heat source. The temperature of the heat source can be regulated to prevent the polymer from being degraded due to overheating.

The amount of the solvent to be fed later during solvent replacement is undesirably too small or too large because such a too-small amount cannot allow for sufficient removal of a low-boiling point compound, and such a too-large amount leads to time-consuming replacement to provide excess heat history to the polymer. The amount fed can be usually selected from a range of 1.05 times to 10 times, preferably 1.1 times to 5 times, particularly preferably 1.2 times to 3 times the required amount of the solvent of a finished solution.

The replacement solvent is not particularly limited as long as it can dissolve the polymer. For example, if the replacement solvent is for resist use, a known solvent for resist, to be usually used in a resist composition, can be used. Specific examples include solvents such as propylene glycol monomethyl ether acetate, propylene glycol monomethyl ether, propylene glycol n-butyl ether, dipropylene glycol n-propyl ether, dipropylene glycol n-butyl ether, ethyl lactate, methyl amyl ketone, γ-butyrolactone, cyclohexanone, and 4-methyl-2-pentanol.

The solvent replacement may impart replacement with a single solvent, or may impart replacement with a mixed solvent of two or more solvents. In the case of replacement with a single solvent, a solvent to be used in a plurality of solvents used in an objective polymer solution is selected in consideration of the solubility of the polymer in each of such solvents, the difference in boiling point between such solvents, the solvent composition ratio of an objective polymer solution, and the like.

For example, while any solvent in such a plurality of solvents used in an objective polymer solution may be used from the viewpoint of the solubility of the polymer as long as solubility of the polymer can be kept in a subsequent first condensation step, replacement with a solvent higher in solubility of the polymer is more preferred because the polymer solution can be condensed to a high concentration without any concern about polymer precipitation in the first condensation step.

In this regard, in a case where the difference in boiling point between such solvents is large and the composition ratio of a high-boiling point solvent is not so large in an objective solvent composition ratio, replacement with such a high-boiling point solvent may make it impossible to continue the subsequent steps. For example, in the case of production such that the polymer concentration is 50% by mass and the composition ratio X/Y of the mixed solvent is 67/33 (boiling point: X << Y), the composition ratio of a polymer liquid is configured from 100 parts of the polymer, 67 parts of a solvent X, and 33 parts of a solvent Y, it is expected that distillation off of the solvent Y hardly progresses in a second condensation step after addition of the solvent X unless the solvent Y is condensed to 33 parts or less in the first condensation step after the solvent replacement, and therefore an objective composition ratio of X:Y is liable not to be able to be achieved. However, condensation of the solvent Y to 33 parts by mass based on 100 parts of the polymer in the first condensation step can probably cause precipitation of a large amount of the polymer and is impractical. In such a case, replacement with a low-boiling point solvent X is more preferred in the solvent replacement step.

[Filtration step]

The polymer solution is preferably filtrated by a filter in order to remove a microgel which is not preferred because of causing pattern defects in resist, such as a highpolymer. The filtration accuracy of the filter is 0.2 μm or less, preferably 0.1 μm or less, particularly preferably 0.05 μm or less. Examples of the material of the filter can include polyolefins such as polyethylene and polypropylene, polar group-containing resins such as polyamide, polyester and polyacrylonitrile, and fluorine-containing resins such as fluorinated polyethylene, and polyamide is particularly preferred. Examples of the polyamide-based filter can include (hereinafter, trademark) Ultipleat P-nylon 66 and Ultipor N66 manufactured by Pall Corporation, and LifeASSURE PSN series and LifeASSURE EF series manufactured by CUNO Inc. Examples of the polyolefin-based filter can include Microgard Plus HC10 and Optimizer D manufactured by Entegris Japan Co., Ltd. These filters may be each used singly or may be used in combination of two or more kinds thereof.

The filtration step may be performed after the purification step, may be performed after the solvent replacement step, or may be performed after both steps.

[Preparation of polymer solution containing solvents]

The method of the present invention produces a polymer solution containing C% by mass of a polymer in a mixed solvent of at least two or more solvents mixed at a predetermined mass ratio.

The type of each of the solvents is not limited as long as the polymer can be homogeneously dissolved. For example, the same types of solvents as in the above replacement solvent can be used in the mixed solvent. In the case of a resist polymer solution, the same types of solvents for resist as those used in a resist composition are preferably contained.

The mass ratio of each of the solvents is not limited as long as the polymer can be homogeneously dissolved. In a case where n types of solvents are contained in the mixed solvent in the present invention, the respective solvents are designated as a first solvent, ..., and an n-th solvent, and the concentrations of the respective solvents satisfy the first solvent ≥ ... ≥ the n-th solvent. For example, in a case where two types of solvents are contained in the mixed solvent, the concentration of the first solvent is preferably 45% by mass or more and less than 80% by mass, more preferably 50% by mass or more and 75% by mass or less, and the concentration of the second solvent is preferably 20% by mass or more and 50% by mass or less, more preferably 25% by mass or more and 50% by mass or less, based on the total mass of the mixed solvent. In a case where three types of solvents are contained in the mixed solvent, the concentration of the third solvent is preferably more than 0% by mass and less than 20% by mass, more preferably 1% by mass or more and 15% by mass or less based on the total mass of the mixed solvent.

The polymer concentration C is also not limited as long as the polymer can be homogeneously dissolved. In a case where the polymer solution is a resist polymer solution, the polymer concentration C is preferably 20 to 70% by mass, and in particular, in a case where the polymer solution is a resist polymer solution for thick films, the polymer concentration C is more preferably 30 to 70% by mass, further preferably 35 to 65% by mass.

The present invention relates to a method for producing a polymer solution containing C% by mass of a polymer in a mixed solvent of at least two or more solvents mixed at a predetermined mass ratio, in which an objective polymer solution is produced by estimating the polymer concentration and the solvent composition ratio of a "prepolymer solution" in which the solvent composition ratio in condensation of a polymer solution containing all the solvents, to an objective concentration of C% by mass, is also just a predetermined value, thereby preparing and then condensing the prepolymer solution.

[Setting of prepolymer solution]

The prepolymer solution mentioned in the present invention means a polymer solution having a lower polymer concentration than and containing the same types of solvents as the polymer solution containing at least two or more solvents, to be produced in the present invention, in which the solvent composition ratio in condensation to an objective value of the polymer concentration is an objective composition ratio.

While a polymer concentration of Ck% by mass in the prepolymer solution needs to be lower than a polymer concentration of C% by mass in an objective polymer solution, a too-low polymer concentration of Ck% by mass is not preferred because the amount of the solvents disposed by condensation is increased. A preferred range of Ck is 0.3 C or more and 0.8 C or less, more preferably 0.4 C or more and 0.7 C or less.

The solvent composition ratio of the prepolymer solution needs to be set so as to achieve a desired composition ratio in condensation of the prepolymer solution from a polymer concentration of Ck to an objective concentration C. The solvents differ in boiling point and vapor pressure depending on the types thereof, and therefore the degree of distillation off of the mixed solvent in condensation with distillation needs to be estimated. The data of the respective degrees of volatility of the solvents used in the design of distillation is variously available, and can also be simulated from, for example, the correlation diagram of gas phase composition ratio/liquid phase composition ratio in gas-liquid equilibrium.

A simple method can be made which involves calculating and determining the proportion of each of the solvents remaining in the bottom in consideration of condensation of a prepolymer solution having a polymer concentration of Ck% by mass, to a polymer concentration of C% by mass, temporarily setting the solvent composition ratio before the condensation, with reference to the boiling point and the vapor pressure of each of the solvents, and condensing the mixed solvent having the composition ratio temporarily set, to the proportion calculated and determined, to confirm the change in solvent composition ratio in what manner.

Specifically, the mass ratio of each of the solvents in the prepolymer solution can be determined by the following preliminary test.

(Procedure of preliminary test)

The degree R of solvent condensation of in the case of condensation of the prepolymer solution having a polymer concentration of Ck% by mass, to a polymer concentration of C% by mass, can be calculated by the following calculation expression.

$$R = (100 - C)/(100 \times C/Ck - C)$$

Subsequently, a mixed solvent in which the composition ratio of a solvent considered to be more distilled off during distillation with reference to the boiling point and the vapor pressure of each of the solvents is higher than a target composition ratio is prepared, and distilled until the total mass of the mixed solvent is decreased to a value obtained by multiplication with the degree R of solvent condensation, and determining the solvent composition ratio after distillation. A mixed solvent composition ratio which allows the solvent composition ratio after distillation to be equal to a target composition ratio is determined, and the mixed solvent composition ratio is defined as the mass ratio of each of the solvents in the prepolymer solution.

For example, in a case where production of a polymer solution containing two solvents (H and L) different in boiling point, and having a polymer concentration of 50% by mass and satisfying H:L = 50:50 (mass ratio) by condensation of a prepolymer solution having a polymer concentration of 30% by mass is expected, it is indicated that the degree R of solvent condensation is 0.43 and a polymer concentration of 50% is achieved by condensation with solvent removal until 70 parts by mass of the solvents contained in 100 parts by mass of the solution having a polymer concentration of 30% is decreased to $70 \times 0.43 \approx 30$ parts by mass.

The solvent L lower in boiling point is more distilled off during distillation, therefore a mixed solvent at a mass ratio H:L of 45:55, 40:60, or the like is prepared in consideration of the difference in boiling point between the solvents H and L, and a solvent composition ratio at which the mass ratio H:L in distillation until the mass of the mixed solvent is decreased to 43% approximates 50:50 is found and set as the solvent composition ratio of the prepolymer solution.

[First condensation step]

The first condensation step is a step of condensing a solution of the polymer dissolved in at least one solvent of the solvents (= mixed solvent whose type is the same as that of an objective polymer solution) contained in the prepolymer solution so that the polymer concentration is Cz ($0.8C < Cz \leq C + 10$) % by mass, before preparation of the prepolymer solution.

Such a polymer solution to be subjected to the first condensation step may be prepared by dissolving a polymer powder in the solvent, or may be a polymer solution obtained by formation of the polymer with polymerization reaction. Such a polymer solution obtained by polymerization reaction is preferably used in that a drying step of providing a polymer powder and a step of re-dissolving the polymer powder in the solvent can be omitted and furthermore polymer denaturation due to heat history in the drying step can be prevented. Such a polymer solution obtained by polymerization reaction is preferably subjected to the first condensation step, after the polymer solution undergoes the above-mentioned purification step, solvent replacement step, filtration step and the like, thereby removing impurities, for example, the unreacted monomer, a polymerization initiator-derived by-product, and the solvents used in polymerization and purification, and replacing the solvents with a desired solvent. The first condensation step may be made by continuing distillation under reduced pressure directly after the solvent replacement step.

[Prepolymer solution preparation step]

The prepolymer solution preparation step is to add a required amount of a required solvent, to the polymer solution obtained in the first condensation step, to prepare a prepolymer solution having the polymer concentration Ck and the solvent composition ratio set in the above-mentioned method.

[Second condensation step]

The second condensation step is to condense the prepolymer solution by distillation under reduced pressure until the polymer concentration reaches C% by mass. While heating may be made so as not to make stirring of the polymer solution impossible and precipitate the polymer due to an increase in viscosity of the polymer solution by condensation, denaturation of a polymer for resist by heating needs to be attended. The temperature in distillation is preferably 70°C or less, more preferably 60°C or less, further preferably 50°C or less. The degree of pressure reduction in distillation is preferably 20 kPa or less, more preferably 10 kPa or less, further preferably 5 kPa or less.

The end point of the second condensation step can be determined with the amount of a solvent distilled off or the mass of the entire polymer solution, according to calculation based on the polymer concentration of the prepolymer solution.

The solvent composition ratio (mass ratio) of the polymer solution after the second condensation step preferably reaches a target composition ratio within ± 5%.

[Component adjustment step]

The polymer concentration C and the solvent composition ratio in the second condensation step, when are slightly shifted from objective values, may be adjusted to the objective values by further condensation and/or addition of a proper amount of a required solvent, and then stirring and homogenization of the polymer solution.

EXAMPLES

The present invention is described in further detail with reference to Examples, but the present invention is not limited to these Examples.

Table 1 summarizes target properties of each polymer solution produced in Examples and Comparative Examples.

[Table 1]

| Production targets | | | |
|---|---|---|---|
| | Polymer*1 | Polymer concentration (% by mass) | Solvent composition ratio (mass ratio)*2 |
| Example 1 | PHS/TBA | 50 | PGMEA: PGME = 50:50 |
| Example 2 | PHS/TBA | 50 | PGMEA: PGME = 50:50 |
| Example 3 | PHS/Oa | 40 | PGMEA: PGME = 50:50 |
| Example 4 | PHS/Oa | 40 | PGMEA: PGME = 50:50 |
| Example 5 | PHS/TBA | 50 | PGMEA: PGME = 70:30 |
| Example 6 | PHS/TBA | 50 | PGMEA: PGME = 30:70 |

(continued)

| Production targets | | | |
|---|---|---|---|
| | Polymer*1 | Polymer concentration (% by mass) | Solvent composition ratio (mass ratio)*2 |
| Example 7 | PHS/TBA | 50 | BuOAc: PGME = 50:50 |
| Example 8 | PHS/TBA | 50 | 2-Heptanone: PGME = 50:50 |
| Example 9 | PHS/TBA | 45 | DMAc: PGMEA = 50:50 |
| Example 10 | PQMA/TBA | 50 | PGMEA: PGME = 50:50 |
| Example 11 | PHS homopolymer | 50 | PGMEA: PGME = 50:50 |
| Example 12 | PQMA/TBA | 60 | PGMEA: PGME = 40:60 |
| Comparative Example 1 | PHS/TBA | 50 | PGMEA: PGME = 50:50 |
| Comparative Example 2 | PHS/TBA | 50 | PGMEA: PGME = 50:50 |

Abbreviations in Table 1 are as follows.

*1

PHS: 4-hydroxystyrene
TBA: tert-butyl acrylate
Oa: 3-hydroxy-1-adamantyl acrylate
PQMA: 4-hydroxyphenyl methacrylate

*2

PGMEA: propylene glycol monomethyl ether acetate
PGME: propylene glycol monomethyl ether
BuOAc: butyl acetate
DMAc: dimethylacetamide

[Solvent composition ratio of polymer solution]

The solvent composition ratio of the mixed solvent was analyzed by gas chromatography.

Apparatus: GC-2010plus manufactured by Shimadzu Corporation
Carrier gas: $N_2$
Detector: FID
Column: DB-5 (15 m) manufactured by Agilent J&W

[Quantitative determination of low-molecular weight component in polymer]

Each low-molecular weight component contained in the polymer solution was quantitatively determined by analysis with liquid chromatography.

Measurement apparatus: HLC-8320GPC manufactured by Tosoh Corporation
Detector: differential refractive index (RI) detector
Column: TOSOH TSKgel super HZ1000 × 4
Eluent: tetrahydrofuran
Flow rate: 0.35 mL/min
Temperature: 40°C

[Water content in polymer solution]

The water content in the polymer solution was analyzed according to the Karl Fischer's method.

Apparatus: Karl Fischer type aquameter AQ-2200 by coulometric titration method, manufactured by HIRANUMA Co., Ltd.
Electrolyte-generator electrolyte: HYDRANAL Coulomat AK from Sigma-Aldrich
Electrolyte-counter electrolyte: HYDRANAL Coulomat CG-K from Sigma-Aldrich

[Polymer concentration]

The polymer concentration in the polymer solution was quantitatively determined by the following procedure.
One portion of the polymer solution was sampled and metered, and dried with the metering container at 100°C under reduced pressure, and the mass of the remaining dry polymer was measured. The dry polymer was re-dissolved in tetrahydrofuran, and the amount of the remaining solvent in the dry polymer was quantitatively determined by GC analysis. The polymer concentration was defined as a value obtained by subtracting the amount of the remaining solvent in the dry polymer from the mass of the dry polymer, and dividing the difference by the sampling mass.

[Weight average molecular weight-molecular weight distribution of polymer]

The weight average molecular weight and the molecular weight distribution of a polymer synthesized as described below were measured by GPC (gel permeation chromatography) with polystyrene as a standard. A sample for analysis was prepared as a tetrahydrofuran solution in which the solid content concentration of the polymer was 2% by mass. The amount of the sample injected to an apparatus was 50 μL.

Measurement apparatus: HLC-8220GPC manufactured by Tosoh Corporation
Detector: differential refractive index (RI) detector
Column: Shodex GPC KF804 × 3 (manufactured by Showa Denko K.K.)
Eluent: tetrahydrofuran
Flow rate: 1.0 mL/min
Temperature: 40°C
Calibration curve: created with polystyrene standard sample (manufactured by Tosoh Corporation)

[Monomer composition ratio of polymer]

The monomer composition ratio of a polymer synthesized as described below was analyzed with $^{13}$C-NMR.

Apparatus: Ascend 400 manufactured by Bruker
Deuterated solvent: acetone-d6
Relaxation reagent: chromium(III) acetylacetonate
Measurement temperature: 30°C

[Metal analysis in polymer]

The contents of metals in a polymer synthesized as described below were analyzed by high-frequency inductively coupled plasma mass spectrometry (ICP-MS). The metals subjected to measurement were 26 elements in total of Na, K, Mg, Al, Ca, Cr, Mn, Fe, Ni, Cu, Zn, Pb, Sn, Co, Li, Ti, Ag, W, V, Ba, Pt, Au, As, Cd, Mo, and Zr. The analysis values were based on the mass of the polymer solid content.

Apparatus: ICP mass spectrometer (trade name: Agilent 7500cs, manufactured by Agilent Technologies)
Sample preparation: polymer solution diluted with N-methyl-2-pyrrolidone

[Example 1]

(Polymerization step)

A p-hydroxystyrene composition (p-hydroxystyrene 25% by mass, p-ethylphenol 41% by mass, methanol 23% by mass, water 11%) obtained by dehydrogenation of p-ethylphenol, and tert-butyl acrylate were dissolved in methanol so that the molar ratio between the monomers was 65:35, and AIBN was added as a polymerization initiator, to prepare a monomer solution.
One-quarter of the monomer solution was loaded to a reaction vessel equipped with a stirrer, a condenser and a thermometer, and placed in a nitrogen atmosphere and then heated to 80°C with stirring. The remaining three-quarters of

the monomer solution were dropped and fed thereto at a constant rate over 3 hours, thereafter continued to be subjected to polymerization reaction for additional 1 hour, and thereafter cooled to room temperature.

(Purification step)

A polymerization liquid was purified by precipitation with toluene as a poor solvent and acetone as a good solvent according to a known method, to remove impurities contained in the polymer, for example, the polymerization solvent and the unreacted monomers. Thereafter, the polymer was re-dissolved in ethyl acetate, washed with an aqueous 1% by mass oxalic acid solution, and then repeatedly washed with pure water, to remove metal impurities. The contents of metals in the polymer after water washing were analyzed, and as a result, the contents of Na and Zn were each 2 ppm, the contents of K, Cr, Fe and Sn were each 1 ppb, and the contents of other metal elements were each less than 1 ppb.

PGMEA was gradually added to the ethyl acetate solution of the polymer after water washing, with ethyl acetate in the solution being distilled off at a heat source temperature of 45°C under reduced pressure, and a PGMEA solution was finally obtained in which the polymer concentration was 30% by mass and each of the contents of the low-boiling point solvents such as the polymerization solvent and the purification solvent, and the water content were each less than 0.1%.

Properties of the resulting polymer were as follows: PHS: TBA = 65:35, weight average molecular weight (Mw) = 23,000, and molecular weight distribution (Mw/Mn) = 2.5.

<Determination of concentration Ck and mass ratio of PGMEA and PGME in prepolymer solution>

The polymer concentration Ck of the prepolymer solution was set to 28% by mass. In the case of condensation of the prepolymer solution to 50% by mass in the second condensation step, the degree R of solvent condensation = $(100 - C)/(100 \times C/Ck - C)$ = about 0.4 was satisfied.

Since PGME was considered to be more distilled off in distillation because PGMEA had a boiling point of 146°C and a vapor pressure of 0.5 kPa (20°C) and PGME had a boiling point of 120°C and a vapor pressure of 1.2 kPa (20°C), a preliminary test was performed in which the solvent composition ratio was examined when a mixed solvent having a composition ratio of PGME of more than 50% of the target was prepared and distilled at a degree of pressure reduction of 1 kPa and a temperature of 45°C until the entire mass was decreased to 40%. As a result, when a mixed solvent having a mass ratio of PGMEA/PGME of 40:60 was distilled to a degree of condensation of 40%, a mass ratio of PGMEA/PGME of 52:48 was achieved and a value close to an objective solvent composition ratio was obtained. It was expected from the result that, if the prepolymer solution was adjusted so as to have a polymer concentration of 28% by mass and a mass ratio of PGMEA/PGME of 40/60, a polymer solution having values close to objective polymer concentration and solvent composition ratio was obtained in condensation of the prepolymer solution to a polymer concentration of 50% by mass.

(First condensation step)

Four hundred g of the PGMEA solution obtained in the solvent replacement step, in which the polymer concentration was 30% by mass, was slowly condensed with an evaporator at a heat source temperature of 45°C and a degree of pressure reduction of 1 kPa, to obtain 240 g of a PGMEA solution in which the polymer concentration was 50% by mass. The polymer was observed to be slightly precipitated.

(Prepolymer solution preparation step)

The solution was diluted by addition of 180 g of PGME, to prepare 420 g of a prepolymer solution in which the polymer concentration was 28.6% by mass and the mass ratio of PGMEA: PGME was 40:60.

(Second condensation step)

The prepolymer solution was charged to a flask, and slowly condensed under reduced pressure with an evaporator at a degree of pressure reduction of 6 to 10 kPa and a heat source temperature of 45°C. When the mass of the content in the flask reached 240 g, the condensation was terminated. The polymer solution obtained was analyzed, and as a result, the polymer concentration was 50% by mass and the solvent composition ratio satisfied PGMEA: PGME = 51:49.

[Example 2]

(Polymerization step)

The same polymer solution as in Example 1 was produced at a scale of about 8.3 times (polymer solid content 1.0 kg) that of Example 1.

The polymerization, the purification, and the solvent replacement were performed according to Example 1, to prepare a PGME solution of a PHS/TBA copolymer, in which the polymer concentration was 30% by mass and the low-boiling point solvent content and the water content were each less than 0.1%.

The concentration Ck and the solvent composition ratio of the prepolymer solution were respectively set to the same as those in Example 1 (Ck = 28% by mass, mass ratio of PGMEA/PGME = 40/60).

(First condensation step)

An evaporator was used to slowly condense 3.33 kg of the PGMEA solution obtained in solvent replacement, in which the polymer concentration was 30% by mass, at a heat source temperature of 45°C and a degree of pressure reduction of 1 kPa, until the mass of the polymer solution reached 2.0 kg.

(Prepolymer solution preparation step)

Thereafter, 1.5 kg of PGME was added for dilution, to provide 3.5 kg of a prepolymer solution.

(Second condensation step)

An evaporator was used to slowly condense the prepolymer solution at a heat source temperature of 45°C and a degree of pressure reduction of 6 to 10 kPa, until the mass of the polymer solution reached 2.0 kg. One portion of the resulting polymer solution was sampled and analyzed, and as a result, the polymer concentration was 51.4% by mass, and the solvent composition ratio (mass ratio) satisfied PGMEA: PGME = 52.0:48.0.

(Component adjustment step)

The polymer concentration was slightly higher than a target value, and therefore a small amount of PGME was added for adjustment to a composition ratio closer to targets of a polymer concentration of 50.1% by mass and a solvent composition ratio (mass ratio) of PGMEA: PGME of 50.4:49.6.

[Example 3]

(Polymerization step)

The same p-hydroxystyrene composition as that used in Example 1, and 3-hydroxy-1-adamantyl acrylate were dissolved in isopropanol so that the molar ratio between the monomers was 70:30, and dimethyl 2,2-azobisisobutyrate was added as a polymerization initiator, to prepare a monomer solution.

One-quarter of the monomer solution was loaded to a reaction vessel equipped with a stirrer, a condenser and a thermometer, and placed in a nitrogen atmosphere and then heated to 80°C with stirring. The remaining three-quarters of the monomer solution were dropped and fed thereto at a constant rate over 3 hours, thereafter continued to be subjected to polymerization reaction for additional 1 hour, and thereafter cooled to room temperature.

(Purification step)

A polymerization liquid was purified by precipitation with toluene as a poor solvent and a mixed solvent of isopropanol/methanol as a good solvent, to remove impurities contained in the polymer, for example, the polymerization solvent and the unreacted monomers. Thereafter, the polymer was re-dissolved in methanol, and allowed to pass through a metal removal filter (40QSH manufactured by Sumitomo 3M Limited) having adsorption action due to the Zeta potential and a membrane filter (LifeASSURE manufactured by Sumitomo 3M Limited) made of nylon, having a nominal pore size of 0.04 μm, to remove metal impurities and any fine insoluble component.

(Solvent replacement step)

PGME was gradually added to the polymer solution after filtration treatment, with methanol being distilled off under reduced pressure at a heat source temperature of 45°C, and a PGME solution was finally obtained in which the polymer concentration was 30% by mass and the contents of the low-boiling point solvents such as the polymerization solvent and the purification solvent, and the water content were each less than 0.1%.
The resulting polymer satisfied PHS: Oa = 69:31, and had a weight average molecular weight (Mw) of 12,000 and a molecular weight distribution (Mw/Mn) of 1.6.

<Determination of concentration Ck and mass ratio of PGMEA and PGME in prepolymer solution>

The polymer concentration Ck of the prepolymer solution was set to 23% by mass. In the case of condensation of the prepolymer solution to 40% by mass in the second condensation step, the degree R of solvent condensation = $(100 - C)/(100 \times C/Ck - C)$ = about 0.45 was satisfied.
A preliminary test was performed in the same manner as in Example 1, in which the solvent composition ratio was examined when a mixed solvent of PGMEA/PGME, having a composition ratio of PGME of more than 50% of the target, was prepared and distilled at a degree of pressure reduction of 1 kPa and a temperature of 45°C until the entire mass was decreased to 45%. As a result, when a mixed solvent having a mass ratio of PGMEA/PGME of 38/62 was distilled to a degree of condensation of 45%, a mass ratio of PGMEA/PGME of 50/50 was achieved and was the same value as an objective solvent composition ratio. It was expected from the result that, if the prepolymer solution was adjusted so as to have a polymer concentration of 23% by mass and a mass ratio of PGMEA/PGME of 38/62, a polymer solution having objective polymer concentration and solvent composition ratio was obtained in condensation of the prepolymer solution to a polymer concentration of 40% by mass.

(First condensation step)

Two hundred g of the PGME solution obtained in the solvent replacement step, in which the polymer concentration was 30% by mass, was slowly condensed at a heat source temperature of 45°C and a degree of pressure reduction of 10 kPa, to obtain 167 g of a PGME solution having a polymer concentration of 36% by mass.

(Prepolymer solution preparation step)

The solution was diluted by addition of 76.3 g of PGMEA and 17.5 g of PGME, to prepare 261 g of a prepolymer solution in which the polymer concentration was 23% by mass and the mass ratio of PGMEA: PGME was 38:62.

(Second condensation step)

The prepolymer solution was charged to a flask, and slowly condensed under reduced pressure with an evaporator at a degree of pressure reduction of 10 kPa and a heat source temperature of 45°C. When the mass of the content in the flask reached 150 g, the condensation was terminated. The polymer solution obtained was analyzed, and as a result, the polymer concentration was 40% by mass, and the solvent composition ratio satisfied PGMEA: PGME = 50.6:49.4.

[Example 4]

(Polymerization step)

The same polymer solution as in Example 3 was produced at a scale of about 100 times (polymer solid content 6.0 kg) that of Example 3.
The polymerization, the purification, and the solvent replacement were performed according to Example 1, to prepare a PGME solution of a PHS/Oa copolymer, in which the polymer concentration was 30% by mass and the low-boiling point solvent content and the water content were each less than 0.1%.
The concentration Ck and the solvent composition ratio of the prepolymer solution were respectively set to the same as those in Example 2 (Ck = 23% by mass, mass ratio of PGMEA/PGME = 38/62).

(First condensation step)

An evaporator was used to slowly condense 20.0 kg of the PGMEA solution obtained in solvent replacement, in

which the polymer concentration was 30% by mass, at a heat source temperature of 45°C and a degree of pressure reduction of 1 kPa, until the mass of the polymer solution reached 16.7 kg (polymer concentration 36% by mass).

(Prepolymer solution preparation step)

Thereafter, 1.2 kg of PGME and 7.3 kg of PGMEA were added for dilution, to provide 25.2 kg of a prepolymer solution. (polymer concentration 23.8% by mass and the mass ratio of PGMEA: PGME = 38:62)

(Second condensation step)

An evaporator was used to slowly condense the prepolymer solution at a heat source temperature of 45°C and a degree of pressure reduction of 10 kPa, until the mass of the polymer solution reached 14.5 kg. One portion of the resulting polymer solution was sampled and analyzed, and as a result, the polymer concentration was 41.3% by mass, and the solvent composition ratio (mass ratio) satisfied PGMEA: PGME = 51.8:48.2.

[Example 5]

(Polymerization step)

The same manner as in Example 1 was performed until the polymerization and the purification were completed, and thus an ethyl acetate solution of the polymer was obtained.

(Solvent replacement step)

Thereafter, the replacement solvent was changed to PGME to perform solvent replacement, and a PGME solution was finally prepared in which the polymer concentration was 30% by mass and the low-boiling point solvent content and the water content were each less than 0.1%.

<Determination of concentration Ck and mass ratio of PGMEA and PGME in prepolymer solution>

The polymer concentration Ck of the prepolymer solution was set to 29% by mass. In the case of condensation of the prepolymer solution to 50% by mass in the second condensation step, the degree R of solvent condensation = $(100 - C)/(100 \times C/Ck - C) = 0.41$ was satisfied.

A preliminary test was performed in the same manner as in Example 1, in which the solvent composition ratio was examined when a mixed solvent of PGMEA/PGME, having a composition ratio of PGME of more than 30% of the target, was prepared and distilled at a degree of pressure reduction of 1 kPa and a temperature of 45°C until the entire mass was decreased to 41%. As a result, when a mixed solvent having a mass ratio of PGMEA/PGME of 58/42 was distilled to a degree of condensation of 41%, a mass ratio of PGMEA/PGME of 70/30 was achieved and was the same value as an objective solvent composition ratio. It was expected from the result that, if the prepolymer solution was adjusted so as to have a polymer concentration of 29% by mass and a mass ratio of PGMEA/PGME of 58/42, a polymer solution having objective polymer concentration and solvent composition ratio was obtained in condensation of the prepolymer solution to a polymer concentration of 50% by mass.

(First condensation step)

Two hundred and fifty g of the PGME solution obtained in the solvent replacement step, in which the polymer concentration was 30% by mass, was slowly condensed at a heat source temperature of 45°C and a degree of pressure reduction of 10 kPa, to obtain 150 g of a PGME solution having a polymer concentration of 50% by mass.

(Prepolymer solution preparation step)

The solution was diluted by addition of 107 g of PGMEA and 2.0 g of PGME, to prepare 259 g of a prepolymer solution in which the polymer concentration was 29% by mass and the mass ratio of PGMEA: PGME was 58:42.

(Second condensation step)

The prepolymer solution was charged to a flask, and slowly condensed under reduced pressure with an evaporator at a degree of pressure reduction of 10 kPa and a heat source temperature of 45°C. The mass of the content

in the flask was 139 g, the polymer concentration was 54.1% by mass, and the solvent composition ratio satisfied PGMEA: PGME = 66:34 at the completion of condensation.

(Component adjustment step)

To the solution were added 10.5 g of PGMEA and 0.9 g of PGME, and the resultant was stirred to provide a polymer solution in which the polymer concentration was 50% by mass and the solvent composition ratio of PGMEA: PGME satisfied 70:30.

[Example 6]

The same procedure as in Example 5 was made to prepare a PGME solution of a PHS/TBA copolymer, in which the polymer concentration was 30% by mass and the low-boiling point solvent content and the water content were each less than 0.1%.

<Determination of concentration Ck and mass ratio of PGMEA and PGME in prepolymer solution>

The polymer concentration Ck of the prepolymer solution was set to 39% by mass. In the case of condensation of the prepolymer solution to 50% by mass in the second condensation step, the degree R of solvent condensation = $(100 - C)/(100 \times C/Ck - C) = 0.64$ was satisfied.

A preliminary test was performed in the same manner as in Example 1, in which the solvent composition ratio was examined when a mixed solvent of PGMEA/PGME, having a composition ratio of PGME of more than 70% of the target, was prepared and distilled at a degree of pressure reduction of 1 kPa and a temperature of 45°C until the entire mass was decreased to 64%. As a result, when a mixed solvent having a mass ratio of PGMEA/PGME of 25/75 was distilled to a degree of condensation of 64%, a mass ratio of PGMEA/PGME of 30/70 was achieved and was the same value as an objective solvent composition ratio. It was expected from the result that, if the prepolymer solution was adjusted so as to have a polymer concentration of 39% by mass and a mass ratio of PGMEA/PGME of 25/75, a polymer solution having objective polymer concentration and solvent composition ratio was obtained in condensation of the prepolymer solution to a polymer concentration of 50% by mass.

(First condensation step)

Two hundred and fifty g of the PGME solution obtained in the solvent replacement step, in which the polymer concentration was 30% by mass, was slowly condensed at a heat source temperature of 45°C and a degree of pressure reduction of 10 kPa until the polymer concentration reached 45% by mass.

(Prepolymer solution preparation step)

The solution was diluted by addition of 31 g of PGMEA, to prepare 198 g of a prepolymer solution in which the polymer concentration was 38% by mass and the mass ratio of PGMEA: PGME was 25:75.

(Second condensation step)

The prepolymer solution was charged to a flask, and slowly condensed under reduced pressure with an evaporator at a degree of pressure reduction of 10 kPa and a heat source temperature of 45°C. The mass of the content in the flask was 147 g, the polymer concentration was 51.0% by mass, and the solvent composition ratio satisfied PGMEA: PGME = 32:68 at the completion of condensation.

(Component adjustment step)

To the solution was added 3.5 g of PGME to perform fine adjustment, thereby providing a polymer solution in which the polymer concentration was 50% by mass and the solvent composition ratio of PGMEA: PGME satisfied 30.6:69.4.

[Example 7]

(Polymerization step)

The same manner as in Example 1 was performed until the polymerization and the purification were completed, and thus an ethyl acetate solution of the polymer was obtained.

(Solvent replacement step)

Thereafter, the replacement solvent was changed to butyl acetate to perform solvent replacement, and a butyl acetate solution was finally prepared in which the polymer concentration was 30% by mass and the low-boiling point solvent content and the water content were each less than 0.1%.

<Determination of concentration Ck and mass ratio of butyl acetate: PGME in prepolymer solution >

The polymer concentration Ck of the prepolymer solution was set to 28.6% by mass. In the case of condensation of the prepolymer solution to 40% by mass in the second condensation step, the degree R of solvent condensation = (100 - C)/(100 × C/Ck - C) = 0.40 was satisfied.

Since PGME was considered to be more distilled off in distillation because butyl acetate had a boiling point of 126°C and PGME had a boiling point of 120°C, the mass ratio of butyl acetate/PGME of the prepolymer solution was set to 40/60.

(First condensation step)

Two hundred and fifty g of the butyl acetate solution obtained in the solvent replacement step, in which the polymer concentration was 30% by mass, was slowly condensed at a heat source temperature of 45°C and a degree of pressure reduction of 10 kPa until the polymer concentration reached 50% by mass.

(Prepolymer solution preparation step)

The solution was diluted by addition of 112 g of PGME, to prepare 262 g of a prepolymer solution in which the polymer concentration was 28.6% by mass and the mass ratio of butyl acetate: PGME was 40:60.

(Second condensation step)

The prepolymer solution was charged to a flask, and slowly condensed under reduced pressure with an evaporator at a degree of pressure reduction of 10 kPa and a heat source temperature of 45°C. The polymer solution after condensation, in which the polymer concentration was 46.2% by mass and the solvent composition ratio satisfied butyl acetate: PGME = 48:52, was slightly insufficiently condensed, but was presumed to further approach an objective composition ratio by progression of additional condensation.

[Example 8]

(Polymerization step)

The same manner as in Example 1 was performed until the polymerization and the purification were completed, and thus an ethyl acetate solution of the polymer was obtained.

(Solvent replacement step)

Thereafter, the replacement solvent was changed to 2-heptanone to perform solvent replacement, and a 2-heptanone solution was finally prepared in which the polymer concentration was 30% by mass and the low-boiling point solvent content and the water content were each less than 0.1%.

<Determination of concentration Ck and mass ratio of 2-heptanone and PGME in prepolymer solution>

The polymer concentration Ck of the prepolymer solution was set to 28.6% by mass. In the case of condensation of the prepolymer solution to 40% by mass in the second condensation step, the degree R of solvent condensation = (100 -

C)/(100 × C/Ck - C) = 0.40 was satisfied.

Since PGME was considered to be more distilled off in distillation because 2-heptanone had a boiling point of 151°C and PGME had a boiling point of 120°C, the mass ratio of 2-heptanone: PGME of the prepolymer solution was set to 40:60.

(First condensation step)

Two hundred and fifty g of the 2-heptanone solution obtained in the solvent replacement step, in which the polymer concentration was 30% by mass, was slowly condensed at a heat source temperature of 45°C and a degree of pressure reduction of 10 kPa until the polymer concentration reached 50% by mass.

(Prepolymer solution preparation step)

The solution was diluted by addition of 112 g of PGME, to prepare 262 g of a prepolymer solution in which the polymer concentration was 28.6% by mass and the mass ratio of 2-heptanone: PGME was 40:60.

(Second condensation step)

The prepolymer solution was charged to a flask, and slowly condensed under reduced pressure with an evaporator at a degree of pressure reduction of 10 kPa and a heat source temperature of 45°C. The polymer solution after condensation, in which the polymer concentration was 47.8% by mass and the solvent composition ratio satisfied 2-heptanone: PGME = 47:53, was slightly insufficiently condensed, but was presumed to further approach an objective composition ratio by progression of additional condensation.

[Example 9]

(Polymerization step-solvent replacement step)

The same manner as in Example 1 was performed until the polymerization, the purification, and the solvent replacement were completed, and thus a PGMEA solution was prepared in which the polymer concentration was 30% by mass and the low-boiling point solvent content and the water content were each less than 0.1%.

<Determination of concentration Ck and mass ratio of dimethylacetamide: PGMEA in prepolymer solution>

The polymer concentration Ck of the prepolymer solution was set to 29.0% by mass. In the case of condensation of the prepolymer solution to 45% by mass in the second condensation step, the degree R of solvent condensation = (100 - C)/(100 × C/Ck - C) = 0.50 was satisfied.

Since PGMEA was considered to be more distilled off in distillation because dimethylacetamide had a boiling point of 165°C and PGMEA had a boiling point of 146°C, a preliminary test was performed in which the solvent composition ratio was examined when a mixed solvent having a composition ratio of PGMEA of more than 50% of the target was prepared and distilled at a degree of pressure reduction of 1 kPa and a temperature of 45°C until the entire mass was decreased to 50%. As a result, when a mixed solvent having a mass ratio of dimethylacetamide: PGMEA of 40:60 was distilled to a degree of condensation of 50%, the mass ratio of dimethylacetamide: PGMEA was a value close to 50:50 being an objective value. It was expected from the result that, if the prepolymer solution was adjusted so as to have a polymer concentration of 29% by mass and a mass ratio of PGMEA/PGME of 40:60, a polymer solution having values close to objective polymer concentration and solvent composition ratio was obtained in condensation of the prepolymer solution to a polymer concentration of 45% by mass.

(First condensation step)

Two hundred and fifty g of the PGMEA solution obtained in the solvent replacement step, in which the polymer concentration was 30% by mass, was slowly condensed at a heat source temperature of 45°C and a degree of pressure reduction of 10 kPa until the polymer concentration reached 45% by mass.

(Prepolymer solution preparation step)

The solution was diluted by addition of 19 g of PGMEA and 73 g of dimethylacetamide, to prepare 259 g of a prepolymer solution having a polymer concentration of 29.0% by mass and a mass ratio of dimethylacetamide: PGMEA of

40:60.

(Second condensation step)

The prepolymer solution was charged to a flask, and slowly condensed under reduced pressure with an evaporator at a degree of pressure reduction of 6 to 10 kPa and a heat source temperature of 45°C. The polymer solution after condensation, in which the polymer concentration was 46.3% by mass and the solvent composition ratio satisfied dimethylacetamide: PGMEA = 47:53, was slightly insufficiently condensed, but was presumed to further approach an objective composition ratio by progression of additional condensation.

[Example 10]

(Polymerization step)

Equimolar amounts of 4-hydroxyphenyl methacrylate and tert-butyl acrylate were dissolved in a mixed solvent of PGMEA and acetone (mass ratio 70:30), and dimethyl 2,2-azobisisobutyrate was added as a polymerization initiator, to prepare a monomer solution.

A mixed solvent of PGMEA and acetone (mass ratio 70:30) was loaded to a reaction vessel equipped with a stirrer, a condenser and a thermometer, and placed in a nitrogen atmosphere and then heated to 80°C with stirring. The monomer solution was dropped and fed thereto at a constant rate over 4 hours, thereafter continued to be subjected to polymerization reaction for additional 3 hours, and thereafter cooled to room temperature. A polymerization liquid was analyzed by GC, and as a result, the monomer conversion was 99% or more.

(Solvent replacement step)

After polymerization, no precipitation purification was performed and PGMEA was gradually added with acetone being distilled off by distillation under reduced pressure of the polymerization liquid at a heat source temperature of 40°C, and a PGMEA solution was finally prepared in which the polymer concentration was 30% by mass and the low-boiling point solvent content and the water content were each less than 0.1%.

Properties of the resulting polymer were as follows: 4-hydroxyphenyl methacrylate: tert-butyl acrylate = 50:50, weight average molecular weight (Mw) = 22,500, and molecular weight distribution (Mw/Mn) = 2.4.

<Determination of concentration Ck and mass ratio of PGMEA and PGME in prepolymer solution>

Since the polymer concentration and the mass ratio of a mixed solvent of PGMEA and PGME, of an objective polymer solution, were the same as those in Example 1, the polymer concentration Ck and the mass ratio of PGMEA: PGME in the prepolymer solution were set to the same values as those in Example 1.

Two hundred and fifty g of the PGMEA solution obtained in the solvent replacement step, in which the polymer concentration was 30% by mass, was used, to perform the same manner as in Example 1 until the first condensation step, the prepolymer solution preparation step and the second condensation step were completed. The polymer solution obtained in the second condensation step had a polymer concentration of 51.0% by mass and satisfied a solvent composition ratio (mass ratio) of PGMEA: PGME of 51.0:49.0.

(Component adjustment step)

To the solution were added 0.9 g of PGMEA and 2.0 g of PGME to finely adjust the polymer concentration and the like, thereby finally providing a polymer solution in which the polymer concentration was 50.0% by mass and the solvent composition ratio of PGMEA:PGME satisfied 50.2:49.8.

[Example 11]

A p-hydroxystyrene homopolymer (MARUKA LYNCUR S2, manufactured by Maruzen Petrochemical, weight average molecular weight (Mw) = 5500, molecular weight distribution (Mw/Mn) = 2.0) was dissolved in ethyl acetate, to prepare a solution in which the polymer concentration was 15% by mass. Thereafter, such a polymer solution was washed with an aqueous 1% by mass oxalic acid solution, and then repeatedly washed with pure water, to remove metal impurities.

PGMEA was gradually added to the ethyl acetate solution of the polymer after water washing, with ethyl acetate in the solution being distilled off at a heat source temperature of 45°C under reduced pressure, and a PGMEA solution was finally obtained in which the polymer concentration was 30% by mass, and the contents of the low-boiling point solvents

such as the polymerization solvent and the purification solvent, and the water content were each less than 0.1%.

<Determination of concentration Ck and mass ratio of PGMEA and PGME in prepolymer solution>

Since the polymer concentration and the mass ratio of a mixed solvent of PGMEA and PGME, of an objective polymer solution, were the same as those in Example 1, the polymer concentration Ck and the mass ratio of PGMEA and PGME in the prepolymer solution were set to the same values as those in Example 1.

Two hundred and fifty g of the PGMEA solution obtained in the solvent replacement step, in which the polymer concentration was 30% by mass, was used, to perform the same manner as in Example 1 until the first condensation step, the prepolymer solution preparation step and the second condensation step were completed. The polymer solution obtained in the second condensation step had a polymer concentration of 53.4% by mass and satisfied a solvent composition ratio of PGMEA: PGME of 53.3:46.7.

(Component adjustment step)

To the solution were added 2.5 g of PGMEA and 6.8 g of PGME to finely adjust the polymer concentration and the like, thereby finally providing a polymer solution in which the polymer concentration was 50.1% by mass and the solvent composition ratio of PGMEA: PGME satisfied 50.0:50.0.

[Example 12]

(Polymerization step)

4-Hydroxyphenyl methacrylate and tert-butyl acrylate were dissolved in a mixed solvent of PGMEA and acetone (mass ratio 70:30) so that the molar ratio between the monomers was 10:90, and dimethyl 2,2-azobisisobutyrate was added as a polymerization initiator, to prepare a monomer solution.

A mixed solvent of PGMEA and acetone (mass ratio 70:30) was loaded to a reaction vessel equipped with a stirrer, a condenser and a thermometer, and placed in a nitrogen atmosphere and then heated to 80°C with stirring. The monomer solution was dropped and fed thereto at a constant rate over 4 hours, thereafter continued to be subjected to polymerization reaction for additional 3 hours, and thereafter cooled to room temperature. A polymerization liquid was analyzed by GC, and as a result, the monomer conversion was 99% or more.

(Solvent replacement step)

After polymerization, no precipitation purification was performed and PGMEA was gradually added with acetone being distilled off by distillation under reduced pressure of the polymerization liquid at a heat source temperature of 40°C, and a PGMEA solution was finally prepared in which the polymer concentration was 32.8% by mass and the low-boiling point solvent content and the water content were each less than 0.1%.

Properties of the resulting polymer were as follows: 4-hydroxyphenyl methacrylate: tert-butyl acrylate = 10:90, weight average molecular weight (Mw) = 21,400, and molecular weight distribution (Mw/Mn) = 2.76.

<Determination of concentration Ck and mass ratio of PGMEA and PGME in prepolymer solution>

The polymer concentration Ck of the prepolymer solution was set to 40% by mass. In the case of condensation of the prepolymer solution to 60% by mass in the second condensation step, the degree R of solvent condensation = $(100 - C)/(100 \times C/Ck - C) = 0.44$ was satisfied.

The solvent composition ratio of the prepolymer solution of Example 12 was estimated as follows, with reference to Example 1. In Example 1, when the solvent composition ratio of the prepolymer solution satisfied PGMEA: PGME mass ratio = 40:60, an objective solvent composition ratio, a mass ratio of PGMEA: PGME of 50:50 was achieved at the degree R of solvent condensation of 0.40. In Example 12, R = 0.44 was satisfied and thus the proportion of the solvent distilled off was lower than that in Example 1, and it could be thus expected that the change in composition ratio of PGMEA and PGME was also lower than that in Example 1. Accordingly, the range of variation in solvent composition ratio was estimated to be about 7% and the solvent composition ratio, the mass ratio of PGMEA:PGME, in the prepolymer solution was set to 33:67 based on an objective solvent composition ratio, a mass ratio of PGMEA:PGME, of 40:60.

(First condensation step)

Three hundred g of the PGMEA solution obtained in the solvent replacement step, in which the polymer

concentration was 32.8% by mass, was slowly condensed with an evaporator at a heat source temperature of 50°C and a degree of pressure reduction of 1 kPa, to obtain 147 g of a PGMEA solution having a polymer concentration of 67.0% by mass.

(Prepolymer solution preparation step)

The solution was diluted by addition of 100 g of PGME, to prepare 247 g of a prepolymer solution in which the polymer concentration was 39.8% by mass and the mass ratio of PGMEA: PGME was 32.7:67.2.

(Second condensation step)

The prepolymer solution was slowly condensed with an evaporator under reduced pressure at a degree of pressure reduction of 1 to 10 kPa and a heat source temperature of 50°C. When the mass of the content in the flask reached 164 g, the condensation was terminated. The polymer solution obtained was analyzed, and as a result, the polymer concentration was 60.0% by mass and the solvent composition ratio satisfied PGMEA: PGME = 43.5:56.5.

[Comparative Example 1]

A method for preparing an objective polymer solution was tried which included preparing a polymer solution having a very high concentration with PGMEA as a solvent, and adding PGME thereto.
The same procedure as in Example 1 was made to perform polymerization of p-hydroxystyrene and tert-butyl acrylate, purification, and solvent replacement, and thus 1 kg of a PGMEA solution was prepared in which the polymer concentration was 30% by mass and the contents of the low-boiling point solvents such as the polymerization solvent and the purification solvent, and the water content were each less than 0.1%.
Since a PGMEA solution in which the polymer concentration was 66.7% by mass was needed to allow for a polymer concentration of 50% by mass and a mass ratio of PGMEA and PGME of 50:50 after PGME addition, the polymer solution after the solvent replacement was further condensed under reduced pressure at 45°C. The condensation was continued until the amount of liquid (442 g) corresponding to a polymer concentration of about 68% by mass was achieved, and then the polymer was remarkably precipitated. Thereto were added 8 g of PGMEA and 150 g of PGME, and the resultant was stirred in order to re-dissolve the polymer precipitated. 24 hours or more was taken until the polymer was redissolved to provide a homogeneous polymer solution. While a polymer solution having an objective composition ratio was finally obtained, not only a long preparation time was taken, but also a large amount of a solid having a high viscosity was precipitated, and therefore it was found that the risk of stopping of stirring, failure of a stirring apparatus, and the like was increased.

[Comparative Example 2]

The same procedure as in Example 1 was made to perform polymerization and purification of p-hydroxystyrene and tert-butyl acrylate, to provide an ethyl acetate solution of a polymer. The polymer solution was transferred to a tray, and the solvent was evaporated to dryness at a degree of pressure reduction of 10 kPa to 1 kPa and a temperature of 50°C, to provide a polymer powder. 24 hours or more was taken until the concentration of ethyl acetate contained in the polymer reached less than 1% by mass.
While 700 g of PGMEA and 300 g of PGME were added to 1 kg of the polymer powder and stirred in order to prepare a polymer solution having an objective composition ratio, the polymer was not completely redissolved even after stirring for 1 hour or more.

Industrial Applicability

The present invention can be utilized for production of a resist polymer solution suitable for preparation of a resist composition, in particular, a resist composition for thick films.

## Claims

**1.** A method for producing a polymer solution containing C% by mass of a polymer in a mixed solvent of at least two or more solvents mixed at a predetermined mass ratio, the method comprising
the following steps:

a first condensation step: a step of condensing a solution of the polymer dissolved in at least one solvent of the mixed solvent so that a polymer concentration of Cz ($0.8C < Cz \leq C + 10$) % by mass is achieved,
a prepolymer solution preparation step: a step of adding the solvents used in the mixed solvent to the polymer solution obtained in the first condensation step, to prepare a prepolymer solution, in which
the prepolymer solution is a solution containing the polymer at a concentration of Ck ($0.3C \leq Ck \leq 0.8C$) % by mass in the mixed solvent, in which, when the prepolymer solution is condensed from a polymer concentration of Ck% by mass to a polymer concentration of C% by mass, a mass ratio between the at least two or more solvents of the mixed solvent is within $\pm5\%$ of the predetermined mass ratio, and
a second condensation step: a step of condensing the prepolymer solution to a polymer concentration of C% by mass.

**2.** The method for producing a polymer solution according to claim 1, wherein a mass ratio of each of the solvents in the prepolymer solution is determined by the following preliminary test:
(Procedure of preliminary test)

a polymer concentration of Ck% by mass of the prepolymer solution is set, and a degree R of solvent condensation $\{= (100 - C)/(100 \times C/Ck - C)\}$ in the case of condensation of the prepolymer solution to a polymer concentration of C% by mass in the second condensation step is calculated, and
subsequently, a mixed solvent in which a composition ratio of a solvent considered to be more distilled off during distillation with reference to a boiling point and a vapor pressure of each of the solvents is higher than a target composition ratio is prepared, and distilled until a total mass of the mixed solvent is decreased to a value obtained by multiplication with the degree R of solvent condensation, and determining a solvent composition ratio after distillation, and a mixed solvent composition ratio allowing the solvent composition ratio after distillation to be equal to the target composition ratio is determined and the mixed solvent composition ratio is defined as the mass ratio of each of the solvents in the prepolymer solution.

**3.** The method for producing a polymer solution according to claim 1 or 2, further comprising a solvent replacement step: a step of adding at least one solvent of the mixed solvent to the polymer-containing solution and at the same time distilling the solvent under reduced pressure, to decrease any other low-boiling point impurities than the solvent, before the first condensation step.

**4.** The method for producing a polymer solution according to claim 1 or 2, further comprising a component adjustment step: a step of adding a solvent to the polymer solution to modulate a polymer concentration and a mixed solvent composition ratio, after the second condensation step.

**5.** The method for producing a polymer solution according to claim 1 or 2, wherein the polymer concentration C in the polymer solution is 30 to 70% by mass.

**6.** The method for producing a polymer solution according to claim 1 or 2, wherein a concentration of a first solvent is 45% by mass or more and less than 80% by mass and a concentration of a second solvent is 20% by mass or more and 50% by mass or less based on a total mass of the mixed solvent of the polymer solution.

**7.** The method for producing a polymer solution according to claim 1 or 2, wherein the polymer is a polymer for resist and the mixed solvent is a solvent for resist.

**INTERNATIONAL SEARCH REPORT**

International application No.
**PCT/JP2023/015279**

**A. CLASSIFICATION OF SUBJECT MATTER**

***C08J 3/02***(2006.01)i; ***C08F 212/14***(2006.01)i; ***C08F 220/18***(2006.01)i; ***G03F 7/039***(2006.01)i
FI: C08J3/02 C; C08F212/14; C08F220/18; G03F7/039 601

According to International Patent Classification (IPC) or to both national classification and IPC

**B. FIELDS SEARCHED**

Minimum documentation searched (classification system followed by classification symbols)

C08J3/02; C08F212/14; C08F220/18; G03F7/039

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2007-146022 A (DAICEL CHEM IND LTD) 14 June 2007 (2007-06-14) claims, paragraphs [0073]-[0075], [0080]-[0082], [0090]-[0094], examples | 1-7 |
| X | JP 2007-292937 A (DAICEL CHEM IND LTD) 08 November 2007 (2007-11-08) claims, paragraphs [0070]-[0072], [0080]-[0083], [0090]-[0099], examples | 1-7 |
| A | WO 03/082933 A1 (DAICEL CHEM IND LTD) 09 October 2003 (2003-10-09) claims, examples, entire text | 1-7 |
| A | JP 2006-176574 A (DAICEL CHEM IND LTD) 06 July 2006 (2006-07-06) claims, examples, entire text | 1-7 |
| A | WO 2021/065982 A1 (MARUZEN PETROCHEM CO LTD) 08 April 2021 (2021-04-08) claims, examples, entire text | 1-7 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 July 2023** | **18 July 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/015279**

| Patent document cited in search report | Publication date (day/month/year) | Patent family member(s) | Publication date (day/month/year) |
|---|---|---|---|
| JP 2007-146022 A | 14 June 2007 | (Family: none) | |
| JP 2007-292937 A | 08 November 2007 | (Family: none) | |
| WO 03/082933 A1 | 09 October 2003 | JP 2006-37117 A | |
| | | US 2005/0100815 A1<br>claims, examples, entire text | |
| | | JP 2006-161052 A | |
| | | JP 2006-274276 A | |
| | | JP 4286151 B2 | |
| | | US 2006/0116493 A1 | |
| | | US 2006/0116494 A1 | |
| | | US 2008/0268377 A1 | |
| | | US 2010/0099836 A1 | |
| | | EP 1491560 A1 | |
| | | KR 10-0955989 B1 | |
| | | KR 10-2008-0009220 A | |
| | | TW 200307176 A | |
| JP 2006-176574 A | 06 July 2006 | (Family: none) | |
| WO 2021/065982 A1 | 08 April 2021 | US 2022/0135726 A1<br>claims, examples, entire text | |
| | | CN 113227178 A | |
| | | KR 10-2022-0075265 A | |
| | | TW 202134787 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2018061512 A
- JP 2014127518 A
- JP 2019105847 A
- JP 2005173252 A
- JP 2006161052 A
- JP 2006176574 A